(19) Europäisches Patentamt
European Patent Office
Office européen des brevets

(11) **EP 3 997 030 B1**

(12) **EUROPÄISCHE PATENTSCHRIFT**

(45) Veröffentlichungstag und Bekanntmachung des Hinweises auf die Patenterteilung:
**11.06.2025 Patentblatt 2025/24**

(21) Anmeldenummer: **20739916.3**

(22) Anmeldetag: **07.07.2020**

(51) Internationale Patentklassifikation (IPC):
***B81B 3/00*** *(2006.01)*      ***G02B 26/08*** *(2006.01)*
***H02N 1/00*** *(2006.01)*

(52) Gemeinsame Patentklassifikation (CPC):
**B81B 3/0021; G02B 26/0841; H02N 1/008;**
B81B 2201/033; B81B 2201/042; B81B 2203/053;
B81B 2203/058; B81B 2207/053

(86) Internationale Anmeldenummer:
**PCT/EP2020/069102**

(87) Internationale Veröffentlichungsnummer:
**WO 2021/005046 (14.01.2021 Gazette 2021/02)**

(54) **MEMS-AKTUATOR UND MEMS-AKTUATOR-ARRAY MIT EINER MEHRZAHL VON MEMS-AKTUATOREN**

MEMS ACTUATOR AND MEMS ACTUATOR ARRAY COMPRISING A PLURALITY OF MEMS ACTUATORS

ACTIONNEUR DE TYPE MEMS ET RÉSEAU D'ACTIONNEURS DE TYPE MEMS AYANT UNE PLURALITÉ D'ACTIONNEURS DE TYPE MEMS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.07.2019 DE 102019210026**

(43) Veröffentlichungstag der Anmeldung:
**18.05.2022 Patentblatt 2022/20**

(73) Patentinhaber: **Fraunhofer-Gesellschaft zur Förderung
der angewandten Forschung e.V.
80686 München (DE)**

(72) Erfinder: **DÜRR, Peter
01109 Dresden (DE)**

(74) Vertreter: **Hersina, Günter
Schoppe, Zimmermann, Stöckeler
Zinkler, Schenk & Partner mbB
Patentanwälte
Radlkoferstrasse 2
81373 München (DE)**

(56) Entgegenhaltungen:
**EP-A1- 3 257 808     US-A1- 2004 165 250**

- KWON S ET AL: "High Aspect Ratio Micromirrors With Large Static Rotation and Piston Actuation", IEEE PHOTONICS TECHNOLOGY LETTERS, IEEE SERVICE CENTER, PISCATAWAY, NJ, US, vol. 16, no. 8, 1 August 2004 (2004-08-01), pages 1891 - 1893, XP011115467, ISSN: 1041-1135, DOI: 10.1109/ LPT.2004.831047

**Beschreibung**

Die vorliegende Erfindung bezieht sich auf einen MEMS-Aktuator (MEMS = mikroelektromechanisches System) und dessen Aufbau und ferner auf ein MEMS-Aktuator-Array mit einer Mehrzahl von MEMS-Aktuatoren. Ausführungsbeispiele beziehen sich ferner auf einen MEMS-Aktuator mit digitaler Ansteuerung und gleichmäßig abgestufter Auslenkung. Ausführungsbeispiele beziehen sich ferner auf einen MEMS-Aktuator mit Kammantrieb mit mehreren elektrisch getrennten, festen Elektrodenstrukturen pro MEMS-Aktuator.

MEMS-Aktuatoren gemäß Ausführungsbeispielen können für eine breite Palette von Anwendungen eingesetzt werden wie z. B. Scannerspiegel, optische Schalter für die Kopplung von Lichtfasern ("optical cross-connect"), Mikroventile, elektrische Mikroschalter und andere Anwendungen. Eine weitere relevante Anwendung sind Flächenlichtmodulatoren, bei denen die MEMS-Aktuatoren, die beispielsweise häufig als 2-dimensionales Array angeordnet sind, damit verbundene Mikrospiegel bewegen und wie gewünscht positionieren.

Im Folgenden wird auf den technischen Hintergrund eingegangen, wobei entsprechende Erkenntnisse und technische Schlussfolgerungen der Erfinder bezüglich des technischen Hintergrunds, z. B. unter Bezugnahme auf die zitierten Referenzen, zusammengefasst dargestellt werden.

Meistens wird die Position eines beweglichen Aktuatorelements durch ein angelegtes elektrisches Signal gesteuert. Als physikalischer Effekt wird in vielen Fällen die elektrostatische Anziehungskraft genutzt, wobei aber auch elektromagnetische Kräfte sowie piezoelektrische oder thermische Ausdehnung eingesetzt werden können.

Aufgrund der Art der ausführbaren Bewegung unterscheidet man zwischen drehenden/kippenden Aktuatoren und translatorischen Aktuatoren, sowie Aktuatortypen, die beide Bewegungsarten ermöglichen. Im letzten Fall können die Bewegungskomponenten entweder durch die Art der Aufhängung fest gekoppelt seine, oder durch mehrere Ansteuersignale individuell eingestellt werden (z.B. piston-tip-tilt). Das vorliegende erfindungsgemäße Konzept kann für alle diese Bewegungsarten genutzt werden. Zur Vereinfachung der Beschreibung wird aber hauptsächlich auf translatorischen Aktuatoren eingegangen, speziell solche, die mit Mikrospiegeln zur Phaseneinstellung von daran reflektiertem Licht gekoppelt sind.

Oft sind solche Aktuatoren in großer Anzahl dicht gepackt auf einem Trägersubstrat in einer Ebene angeordnet und die gewünschte Auslenkungsrichtung ist translatorisch senkrecht zu dieser Ebene oder kippend um eine Achse, die in dieser Ebene liegt. Wenn an die Aktuatoren jeweils Mikrospiegel gekoppelt sind bezeichnet man dies auch als Mikrospiegelarray. Die Form und Größe der Mikrospiegel und die nötige Auslenkung sind meist von der Anwendung und optischen Randbedingungen bestimmt. Sehr viele Spiegel (bis zu einigen Millionen) sind oft bevorzugt. Um die Größe des gesamten Arrays im Rahmen zu halten, sollen die einzelnen Spiegel dabei möglichst klein werden. Ihre Größe limitiert aber auch den verfügbaren Platz für die darunter liegenden Speicherzellen der elektronischen Ansteuerung sowie für die konstruktive Auslegung des Aktuators und damit die mögliche Antriebskraft. Die dichte Packung begünstigt ebenfalls ein Übersprechen, so dass ein Aktuator in ungünstiger Weise auch auf das Ansteuersignal der benachbarten Aktuatoren reagieren kann.

Bei den bisher diskutierten Plattenaktuatoren ist das elektrische Feld in brauchbarer Näherung homogen und das bewegliche Aktuatorelement lässt sich weitgehend in Feldrichtung auslenken. Alternativ dazu gibt es Aktuatoren, die oft als Kammantrieb (comb drive) bezeichnet werden. Diese zeichnen sich dagegen dadurch aus, dass inhomogene Randfelder die entscheidende Rolle spielen und sich der bewegliche Teil weitgehend quer zur Richtung des stärksten Teils des elektrischen Feldes auslenken lässt.

Bei den bisher bekannten elektrostatisch angesteuerten analogen Mikrospiegelarrays mit hoher bis sehr hoher Pixelanzahl (etwa >>1000 bis zu einigen Millionen) werden üblicherweise Plattenaktuatoren verwendet [1, 2]. Diese sind relativ einfach im Design und in der Fertigung und können ausreichende Lösungen darstellen.

Das vorliegende erfindungsgemäße Konzept ist geeignet für mikromechanische Aktuatoren, die elektrostatisch angesteuert werden und über eine rückstellende elastische Aufhängung verfügen, die für eine statische Gleichgewichts-Auslenkung eine entsprechende Gegenkraft aufbringt. Die Auslenkung kann damit in einem vorgegebenen Bereich nach Wunsch eingestellt werden und ist nicht durch mechanische Anschläge beschränkt.

Derartige Aktuatoren werden meistens mit einer analogen Spannung zwischen einer (oder zwei) festen Elektrode und dem beweglichen Aktuatorelement angesteuert, siehe z. B. [1, 2]. Es gibt jedoch auch die Möglichkeit der digitalen Ansteuerung. Dafür werden mehrere Elektroden vorgesehen, die dann jeweils wahlweise mit einer von nur zwei möglichen Adressspannungen beaufschlagt werden.

Für eine digitale Ansteuerung werden die Elektroden meist so gestaltet, dass sie einen unterschiedlich großen Einfluss auf die Auslenkung haben, z. B. wie in [3, 4]. Dies kann durch die unterschiedliche Größe der Elektroden oder durch ihren unterschiedlichen Hebelarm zu einer Kippachse des Aktuators bewirkt werden, oder auch durch einen unterschiedlichen wirksamen Abstand der Elektroden von der beweglichen Aktuatorplatte. Solche 'mehrstufige digitale Aktuatoren' haben also im Gegensatz zu den weit verbreiteten binären Aktuatoren (z.B. DMD/DLP von Texas Instruments [5]) mehr als zwei digital ansteuerbare Auslenkpositionen, die nicht durch mechanische Anschläge definiert sind, sondern durch ein Gleichgewicht von elektrostatischen Kräften und Federkräften.

Plattenaktuatoren zeigen jedoch den bekannten pull-in-Effekt, der bei parallelen Platten alle Positionen ab einer Auslenkung von einem Drittel des Anfangsabstandes der Platten bei 0V angelegter Spannung instabil und damit nicht nutzbar macht [1]. Tatsächlich ist die Auslenkungskennlinie in der Näher des pull-ins bereits so steil, dass in der Praxis nur ein deutlich kleinerer Bereich des Anfangsabstandes genutzt werden kann, etwa nur 20%, evtl. 25%. Benötigt man z.B. zur Phasenmodulation von sichtbarem Licht eine Auslenkung von mindestens 320nm (für $2\pi$ Modulationsbereich), so ergibt sich ein Anfangsabstand von mindestens 1,3$\mu$m, besser 1,6$\mu$m. Dieser große Abstand ergibt recht kleine elektrostatische Kräfte (da die Kraft proportional zum Kehrwert des Quadrats des Abstands sinkt) und für Pixelgrößen um oder unter 10$\mu$m auch kaum noch beherrschbares direktes Übersprechen der Elektroden eines Pixels sowie des Nachbarpixels.

Elektrostatische Kammantriebe werden bisher meist in Mikrosystemen mit einzelnen oder wenigen, größeren Aktuatoren (mit Mikrospiegeln oder anderen bewegten Bauteilen wie z.B. der Masse bei Inertialsensoren) eingesetzt, z.B. [7, 8, 9]. Die dabei üblichen Bulkmikromechanischen Fertigungsmethoden haben meist Strukturgrößen (z.B. Fingerbreiten) von mehreren Mikrometern und eignen sich nicht gut für Pixel, die insgesamt nur einige wenige Mikrometer groß sein sollen.

Kammantriebe können für eine Aktuatorauslenkung parallel zu den Elektrodenebenen bzw. Fingern ausgelegt sein oder alternativ im Wesentlichen senkrecht dazu. Letzteres wird oft als vertikaler Kammantrieb bezeichnet, da die Elektrodenebenen meist als Fertigungsebenen parallel zu einer Oberfläche eines Substrats liegen. In diesem Fall ist die Bewegung des Aktuators nach oben und unten nicht durch die Antriebskämme eingeschränkt und es können im resonanten Betrieb sehr große Auslenkungen erreicht werden [7]. Selbstverständlich können die Aktuatoren je nach Fertigungstechnik auch anders orientiert sein, die Argumentation gilt dann entsprechend. Das vorliegende erfindungsgemäße Konzept optimiert derartige vertikale Kammantriebe für die skizzierten Randbedingungen. KWON S ET AL: "High Aspect Ratio Micromirrors With Large Static Rotation and Piston Actuation", IEEE PHOTONICS TECHNOLOGY LETTERS, IEEE SERVICE CENTER, PISCATAWAY, NJ, US, Bd. 16, Nr. 8, 1. August 2004 (2004-08-01), Seiten 1891-1893, ISSN: 1041-1135, DOI: 10.1109/LPT.2004.831047, offenbart Silizium-Mikrospiegel-Bauelemente mit elektrisch voneinander isolierten vertikalen Kammantrieben. Alle Kammfinger werden in einer Silziumschicht so hergestellt, dass isolierte, unabhängig voneinander betreibbare vertikale Kammantriebssätze entstehen, die eine unabhängige Auf- oder Abwärtsbewegung und eine bidirektionale Drehung ermöglichen.

Die bekannten Mikrosysteme mit vertikalem Kammantrieb kann man einteilen in solche, bei denen die Elektroden (Kämme) nach Fertigstellung und ohne angelegte Spannung in einer gemeinsamen Ebene liegen und andere, bei denen die statischen und beweglichen Elektroden jeweils in einer eigenen Ebene liegen. Letzteres kann erreicht werden, indem die Elektroden direkt in verschiedenen Ebenen hergestellt werden z.B. [8], indem der eine Teil der Elektroden durch einen späten Schritt im Fertigungsablauf aus ihrer ursprünglichen Position in eine neue Ruhelage gebracht werden, z.B. [9], oder indem die beiden Elektroden an unterschiedlichen Seiten durch eine gesonderte Ätzung jeweils gekürzt werden z.B. [10]. In allen diesen Fällen entsteht ein Aktuator, der sich beim Anlegen einer statischen Adressspannung analog auslenken lässt. Dagegen kann ein Aktuator mit beiden Elektroden in einer Ebene nur resonant angeregt werden und wäre für die vorliegende Aufgabe nicht geeignet.

Im Fall der Elektroden in zwei Ebenen sind im Stand der Technik solche bekannt, die sich in Ruhelage (ohne angelegte Spannung) bereits überlappen bzw. in einander eingetaucht sind, d.h. die untere Kante des oberen Elektrodenkammes liegt tiefer als die obere Kante des unteren Kammes, wobei die Finger jeweils in den Lücken des anderen Kammes liegen. Dies wird so gewählt, da ein Kammantrieb bei gegebenem Design und Adressspannung seine volle Kraft erst entfaltet, wenn die Kämme in einander eingetaucht sind.

Vertikale Kammantriebe haben den Vorteil, dass sie in der gewünschten Arbeitsrichtung keinen pull-in aufweisen und die Auslenkung daher sogar größer sein kann, als der Ruheabstand der Elektroden. Auch hier ist die gewünschte vertikale Kraft umso größer, je kleiner der horizontale Abstand der Elektrodenkanten ist. Eine untere Schranke für den horizontalen Elektrodenabstand ergibt sich jedoch durch die sehr viel größeren horizontalen Kräfte, die die einzelnen Finger aufeinander ausüben. Bei perfekt gefertigten Systemen addieren sich zwar alle horizontale Kräfte zu Null, aber bereits kleinste Ungenauigkeiten können zu enormen horizontalen Nettokräften führen, die einen solchen Aktuator sogar zerstören können (horizontaler pull-in). Dieser Effekt ist umso kritischer, je größer die Eintauchtiefe ist. Letztere ist natürlich bei Vollauslenkung des Aktuators nochmals größer als in Ruhelage.

Es gibt ebenfalls bekannte Systeme, bei denen die Elektroden in Ruhelage 'Kante auf Kante' liegen oder solche, bei denen ein geringer vertikaler Abstand vorliegt. Letzterer ist meist fertigungsbedingt als Folge einer Ätzstoppschicht oder Verbindungsschicht zwischen den Ebenen aus denen die Elektroden gefertigt wurden.

Bei Mikrospiegelarrays mit sehr vielen Pixeln ist es oft vorteilhaft, die wirkende Spannung in zwei Beiträge zu trennen: eine feste, für alle (oder sehr viele) Elektroden gleiche Spannung, die Biasspannung genannt wird und zu einer von der spannungsfreien Ruhelage verschiedenen Ausgangslage der Aktuatoren führt, sowie eine jeder individuellen Elektrode eigene, je nach gewünschter Position unterschiedliche Adressspannung, die bei digitaler Adressierung aus zwei festen Spannungswerten ausgewählt werden kann. Die Bereitstellung der Biasspannung kann bei begrenzter Adressspannung eine größere Aktuatorkraft bei maximaler Auslenkung erzeugen, so dass härtere Federn zu Einsatz kommen können, was günstig ist für schnelle Schaltzeiten. Andererseits erhöht sich durch die Biasspannung die Gefahr des horizontalen pull-ins.

Bei allen elektrostatischen Aktuatoren ist die Aktuatorkraft bei gegebener Konfiguration und Auslenkung proportional zum Quadrat der Spannung, siehe auch die Formel unten. Zusätzlich steigt die Kraft mit Annäherung des beweglichen Aktuatorelements an die Elektrode weiter, was bei analoger Ansteuerung eine meistens unerwünschte stark nichtlineare Auslenkungskennlinie ergibt. Eine Möglichkeit der Linearisierung der Kennlinie von Plattenaktuatoren ist in [6] beschrieben. Leider lässt sie sich bei sehr kleinen Pixeln ggf. nur schwer anwenden.

Auch bei mehrstufigen digitalen Plattenaktuatoren ergibt sich bei Annäherung des beweglichen Aktuatorelements an die Elektroden in gleicher Weise eine nichtlinear ansteigende Kraft:

$$F_{elektrostatisch} = \frac{\varepsilon_0}{2} A_{Elektrode} \frac{U^2}{(g-d)^2}$$

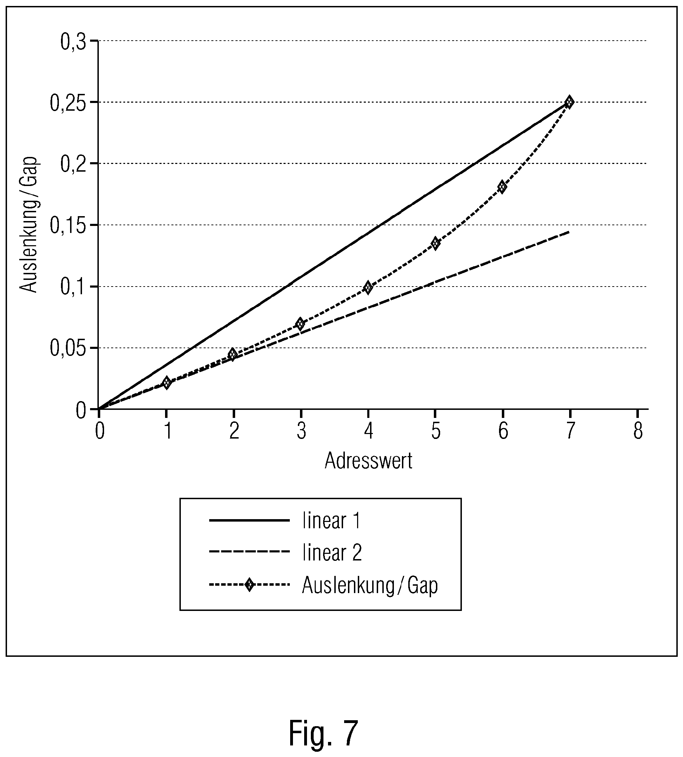

Wobei hier $U$ die anliegende Spannung bezeichnet, $g$ den Abstand (gap) des beweglichen Aktuatorelements von der betrachteten Elektrode in der Ruhelage (ohne anliegende Spannung an allen Elektroden) und $d$ die Annäherung bzw. Auslenkung des Aktuators. Dieser Effekt führt hier dazu, dass der Einfluss jeder Elektrode auf den Betrag der Auslenkung über den aktuellen Wert des wirksamen Plattenabstands ($g - d$) von den Spannungswerten der anderen Elektroden abhängt. Damit erhält man für steigende digitale Ansteuerungswerte ungleichmäßig abgestufte Aktuatorpositionen. Fig. 7 zeigt dies beispielhaft für eine Adressierung mit 3 Bit (= Werte von 0 bis 7) für einen sonst idealen Plattenaktuator im Auslenkungsbereich 0 bis 0,25 des Gaps. Bei großer Auslenkung wird hier nur eine schlechte Auflösung erreicht. Die letzte Stufe (von Adresswert 6 nach 7) ist hier rund 3,4-mal größer als die erste (von 0 nach 1). Wollte man die letzte Stufe nun so klein machen, wie die erste in diesem Beispiel, bräuchte man rund 2 bit mehr in der Adressierung und entsprechend mehr, feiner unterteilte Elektroden. Dies ist gerade für sehr kleine Aktuatoren sehr ungünstig.

Basierend auf dem dargestellten Stand der Technik und den daraus abgeleiteten technischen Erkenntnissen der Erfinder besteht die der vorliegenden Erfindung zugrunde liegende Aufgabe darin, einen diskret angesteuerten, mehrstufigen, elektrostatischen MEMS-Aktuator bereitzustellen, mit dem eine möglichst gleichmäßig abgestufte Auslenkung erreicht werden kann. Dabei soll auch bei sehr kleinen, dicht gepackten MEMS-Aktuatoren die maximale Auslenkung und die Aktuatorkraft möglichst groß sein und ein Übersprechen zwischen den Elektroden bzw. Elektrodenstrukturen eines Pixels wie auch denen der Nachbarpixel möglichst klein sein.

Diese Aufgabe wird durch den MEMS-Aktuator gemäß dem unabhängigen Patentanspruch 1 gelöst. Erfindungsgemäße Weiterbildungen sind in den abhängigen Patentansprüchen definiert.

Ein erfindungsgemäßer MEMS-Aktuator umfasst also ein Substrat, eine erste Elektrodenstruktur, die bezüglich des Substrats feststehend angeordnet ist, wobei die erste Elektrodenstruktur eine Mehrzahl von Teilelektrodenstrukturen aufweist, die jeweils eine Kantenstruktur aufweisen und getrennt voneinander elektrisch ansteuerbar sind, und eine zweite Elektrodenstruktur mit einer Kantenstruktur, wobei die zweite Elektrodenstruktur mittels einer Federstruktur auslenkbar mit dem Substrat gekoppelt ist und mittels der ersten Elektrodenstruktur elektrostatisch auslenkbar ist, um die Kantenstruktur der zweiten Elektrodenstruktur in eine einer Mehrzahl von diskreten Auslenkpositionen zu bewegen, wobei die Kantenstrukturen der ersten und zweiten Elektrodenstruktur hinsichtlich einer Draufsicht gegenüberstehend ausgebildet und die gegenüberstehenden Abschnitte mit einem lateralen Abstand voneinander beabstandet sind, und wobei die einzelnen Teilelektrodenstrukturen der ersten Elektrodenstruktur ausgebildet sind, um basierend auf einer elektrischen Ansteuerspannung eine unterschiedliche, gleichgerichtete elektrostatische Kraft auf die zweite Elektrodenstruktur auszuüben und die zweite Elektrodenstruktur in die jeweilige diskrete Auslenkposition auszulenken.

Ein erfindungsgemäßer MEMS-Aktuator kann eine dritte Elektrodenstruktur umfassen, die bezüglich des Substrats feststehend angeordnet ist, wobei die zweite Elektrodenstruktur zwischen der ersten und dritten Elektrodenstruktur angeordnet und auslenkbar ist. Die zweite Elektrodenstruktur ist mittels der dritten Elektrodenstruktur elektrostatisch auslenkbar, um die Kantenstruktur der zweiten Elektrodenstruktur in eine weitere diskrete Auslenkposition zu bewegen. Dabei sind die erste und dritte Elektrodenstruktur ausgebildet, um bei einer elektrischen Anregung eine entgegengesetzte elektrostatische Kraft auf die zweite Elektrodenstruktur auszuüben.

Gemäß einem weiteren Aspekt weist ein MEMS-Aktuator-Array eine Mehrzahl von

MEMS-Aktuatoren gemäß dem eben genannten Typ auf, und eine Ansteuereinrichtung zum individuellen Ansteuern der jeweiligen Teilelektrodenstrukturen der ersten Elektrodenstrukturen und/oder zum individuellen Ansteuern der jeweiligen dritten Elektrodenstruktur der Mehrzahl von MEMS-Aktuatoren, wobei die zweiten Elektrodenstrukturen der MEMS-Aktuatoren basierend auf der Ansteuerspannung in zumindest eine diskrete Auslenkposition jeweils zwischen der minimalen Auslenkposition und der maximalen Auslenkposition in der ersten Elektrodenstruktur auslenkbar sind, und/oder wobei die zweiten Elektrodenstrukturen der MEMS-Aktuatoren basierend auf der weiteren Ansteuerspannung in zumindest eine diskrete Auslenkposition jeweils zwischen der maximalen Auslenkposition in der ersten Elektrodenstruktur und maximalen Auslenkposition in der dritten Elektrodenstruktur auslenkbar sind.

Gemäß einem Aspekt weist der MEMS-Aktuator eine Ansteuereinrichtung zum selektiven bzw. individuellen Ansteuern zumindest einer Teilmenge der Teilelektrodenstrukturen der ersten Elektrodenstruktur des MEMS-Aktuators mit einem diskreten Spannungswert der Ansteuerspannung, um basierend auf der gewählten Teilmenge von Teilelektrodenstrukturen eine resultierende elektrostatische Kraft auf die zweite Elektrodenstruktur mit einer entsprechenden Änderung der diskreten Auslenkposition der Kantenstruktur der zweiten Elektrodenstruktur zu erhalten.

Gemäß einem Aspekt weist die elektrische Ansteuerspannung eine Mehrzahl von unterschiedlichen, diskreten Spannungswerte auf, wobei basierend auf den unterschiedlichen diskreten Spannungswerten der elektrischen Ansteuerspannung die Kantenstruktur der zweiten Elektrodenstruktur in unterschiedliche, diskrete, vertikal beabstandete Auslenkpositionen auslenkbar ist.

Gemäß einem Aspekt weist die elektrische Ansteuerspannung zwei unterschiedliche, diskrete Spannungswerte auf, um eine digitale Ansteuerung des MEMS-Aktuators bereitzustellen.

Gemäß einem Aspekt weist die erste Elektrodenstruktur "n" Teilelektrodenstrukturen auf, die bei einem diskreten Spannungswert der elektrischen Ansteuerspannung eine um einen vorgegebenen Faktor unterschiedliche, gleichgerichtete elektrostatische Kraft auf die zweite Elektrodenstruktur ausüben, wobei jede der "n" Teilelektrodenstrukturen einer unterschiedlichen Bit-Position eines Bit-Worts zuordenbar ist, wobei die jeweilige Teilelektrodenstruktur einer umso höherwertigen Bit-Bitposition des Bit-Worts zugeordnet ist, je größer bei einer elektrischen Anregung die elektrostatische Kraft dieser Teilelektrodenstruktur auf die zweite Elektrodenstruktur ist, und wobei der Wert des jeweiligen Bits des Bit-Worts den Aktivierungszustand der zugeordneten Teilelektrodenstruktur widergibt.

Gemäß einem Aspekt unterscheiden sich die Teilelektrodenstrukturen der ersten Elektrodenstruktur hinsichtlich ihrer Größe und/oder des jeweiligen lateralen Abstands zu der zweiten Elektrodenstruktur zueinander.

Dabei kann ein höherwertiges Bit des n-Bit-Worts beispielsweise eine größere Wirkung (= Ausübung einer gleichgerichteten elektrostatischen Kraft auf die zweite Elektrodenstruktur) aufweisen als alle anderen niederwertigeren Bits des n-Bit-Worts gemeinsam aufweisen. Die größere Wirkung kann beispielsweise ein (1) LSB (= least significant bit) betragen.

Die Lösung der Problemstellung umfasst beispielsweise die Verwendung eines Kammantriebs mit mehreren elektrisch getrennten festen Elektroden (= getrennt ansteuerbare Teilelektrodenstrukturen der ersten Elektrodenstruktur) pro MEMS-Aktuator. Die Teilelektrodenstrukturen unterscheiden sich in ihrer Größe, z.B. der Anzahl der Finger bzw. der Kantenlänge, und/oder dem horizontalen Abstand zum beweglichen Aktuatorelement, d.h. der auslenkbaren zweiten Elektrodenstruktur, und haben so unterschiedlich starken Einfluss auf die Auslenkung.

Mit Kammantrieben lässt sich eine von der Auslenkung weitgehend unabhängige Kraft erzeugen. Dies sorgt dafür, dass die Abstufung gleichmäßig wird, wenn beispielsweise die folgenden Bedingungen eingehalten werden:

Gemäß einem Aspekt sind die erste und zweite Elektrodenstruktur in einer Ebene parallel zu dem Substrat um den lateralen Abstand beabstandet, wobei die zweite Elektrodenstruktur in der minimalen Auslenkposition in der ersten Elektrodenstruktur eine erste Eintauchtiefe aufweist, wobei die erste Eintauchtiefe bzw. erste Auslenkposition beispielsweise zwischen dem -0,25-fachen (= Abstand), 0-fachen (= bündig) oder 0,5-fachen Wert und dem 1,5-fachen Wert des lateralen Abstands liegt.

Gemäß einem Aspekt weist in einer maximalen Auslenkposition der zweiten Elektrodenstruktur in der ersten Elektrodenstruktur ein vertikaler Überstand zwischen der ersten und zweiten Elektrodenstruktur zumindest den 1-fachen, 1,5-fachen oder 2-fachen Wert des lateralen Abstand auf.

Ausführungsbeispiele der erfindungsgemäßen Konzepts ermöglichen somit, einen digital angesteuerten, mikromechanischen, elektrostatischen MEMS-Aktuator mit großem Auslenkungsbereich bei kleinen lateralen Abmessungen zu realisieren, der gegenüber den in diesem Bereich üblichen Plattenaktuatoren eine verbesserte Abstufung der Auslenkungen sowie ein sehr geringes Übersprechen zwischen Nachbarpixeln zeigt.

Bevorzugte Ausführungsbeispiele werden nachfolgend Bezug nehmend auf die beiliegenden Zeichnungen näher erläutert. Es zeigen:

Fig. 1        eine schematische perspektivische Ansicht eines MEMS-Aktuators gemäß einem Ausführungsbeispiel;

Fig. 2a-b     schematische Teilquerschnittsansichten durch einen Abschnitt der Kantenstruktur der ersten Elektrodenstruktur und einen gegenüberliegenden Abschnitt der Kantenstruktur der zweiten Elektrodenstruktur in einem Anfangszustand (minimaler Adresswert - Fig. 2a) und einem Endzustand (maximaler Adresswert - Fig. 2b) gemäß einem Ausführungsbeispiel;

Fig. 3        einen qualitativen Verlauf der Aktuatorkraft bei fester Ansteuerspannung gegenüber der Eintauchtiefe der zweiten Elektrodenstruktur in der ersten Elektrodenstruktur für einen Kammantrieb gemäß einem Ausführungsbeispiel;

Fig. 4    eine schematische Teilquerschnittsansicht durch einen Abschnitt der Kantenstruktur der ersten Elektrodenstruktur und einen gegenüberliegenden Abschnitt der Kantenstruktur der zweiten Elektrodenstruktur des MEMS-Aktuators mit invertiertem Aufbau gemäß einem weiteren Ausführungsbeispiel;

Fig. 5    eine schematische Teilquerschnittsansicht durch einen Teil eines MEMS-Aktuators gemäß einem weiteren Ausführungsbeispiel, wobei der MEMS-Aktuator als ein doppelt wirkender Aktuator ausgebildet ist;

Fig. 6    eine schematische Aufsicht auf ein regelmäßiges Array von MEMS-Aktuatoren gemäß einem weiteren Ausführungsbeispiel; und

Fig. 7    einen beispielhaften, simulierten Verlauf einer nicht linear abgestuften Auslenkung eines digital angesteuerten achtstufigen Plattenaktuators gemäß dem Stand der Technik.

Bevor nachfolgend Ausführungsbeispiele des vorliegenden Konzepts im Detail anhand der Zeichnungen näher erläutert wird, wird darauf hingewiesen, dass identische, funktionsgleiche oder gleichwirkende Elemente, Objekte, Funktionsblöcke und/oder Verfahrensschritte in den unterschiedlichen Figuren mit den gleichen Bezugszeichen versehen sind, so dass die in unterschiedlichen Ausführungsbeispielen dargestellte Beschreibung dieser Elemente, Objekte, Funktionsblöcke und/oder Verfahrensschritte untereinander austauschbar ist bzw. aufeinander angewendet werden kann.

Verschiedene Ausführungsbeispiele werden nun ausführlicher Bezug nehmend auf die beiliegenden Zeichnungen beschrieben, in denen einige Ausführungsbeispiele dargestellt sind. In den Figuren können Abmessungen von dargestellten Elementen, Schichten und/oder Bereichen zur Verdeutlichung nicht maßstäblich dargestellt sein.

Es versteht sich, dass, wenn ein Element als mit einem anderen Element "verbunden" oder "gekoppelt" bezeichnet wird, es direkt mit dem anderen Element verbunden oder gekoppelt sein kann oder Zwischenelemente vorhanden sein können. Wenn im Gegensatz ein Element als "direkt" mit einem anderen Element "verbunden" oder "gekoppelt" bezeichnet wird, sind keine Zwischenelemente vorhanden. Sonstige zum Beschreiben des Verhältnisses zwischen Elementen benutzten Ausdrücke sollten auf gleichartige Weise ausgelegt werden (z.B. "zwischen" gegenüber "direkt zwischen", "benachbart" gegenüber "direkt benachbart" usw.).

Zur Vereinfachung der Beschreibung der unterschiedlichen Ausführungsbeispiele weisen die Figuren ein kartesisches Koordinatensystem x, y, z auf, wobei die die x-y-Ebene dem Hauptoberflächenbereich des Trägers bzw. Substrats entspricht bzw. parallel zu demselben ist und wobei die vertikale Richtung senkrecht zu der x-y-Ebene ist. In der folgenden Beschreibung bedeutet der Ausdruck "lateral" oder horizontal eine Richtung in der x-y-Ebene (oder parallel dazu), wobei der Ausdruck "vertikal" eine Richtung in der $\pm z$-Richtung (oder parallel dazu) angibt.

Nachfolgende Beispiele beziehen sich auf mikroelektromechanische Systeme (MEMS), die dazu ausgelegt sind, eine bewegliche Elektrodenstruktur auszulenken, die mechanisch mit einem Funktionselement gekoppelt sein kann. Obwohl sich nachfolgende Ausführungsbeispiele auf bewegliche Funktionselemente beziehen, die einen Spiegel, insbesondere einen Mikrospiegel umfassen, so können auch beliebige andere Funktionselemente angeordnet werden, sowohl im optischen Bereich, etwa Linsen, Filter oder dergleichen, aber auch in anderen Bereichen, etwa zum Herstellen eines elektrischen Kontaktes oder dem Verändern eines mechanischen Abstandes.

MEMS können in Halbleitertechnologie hergestellt sein, wobei hierfür insbesondere mehrschichtige Anordnungen in Betracht kommen, darunter leitende, isolierende und halbleitende Schichten, die durch ebensolche Schichten oder Luftspalte beabstandet sein können. MEMS können beispielsweise durch einen mehrschichtigen Lagenaufbau erhalten werden, welcher durch selektives Entfernen von Stapelmaterial, beispielsweise durch einen Ätzprozess, reduziert wird, um MEMS-Strukturen freizulegen. Als Substrat kann beispielsweise ein Siliziummaterial, beispielsweise monokristallines Silizium, polykristallines Silizium oder ein dotiertes Siliziummaterial, verwendet werden. In unterschiedlichen Schichten kann eine Leitfähigkeit erzeugt werden, beispielsweise um die Funktionalität einer Elektrode bereitzustellen. Andere Schichten können beispielsweise metallisiert werden, etwa um eine reflektierende Oberfläche und/oder eine elektrisch leitfähige Oberfläche herzustellen.

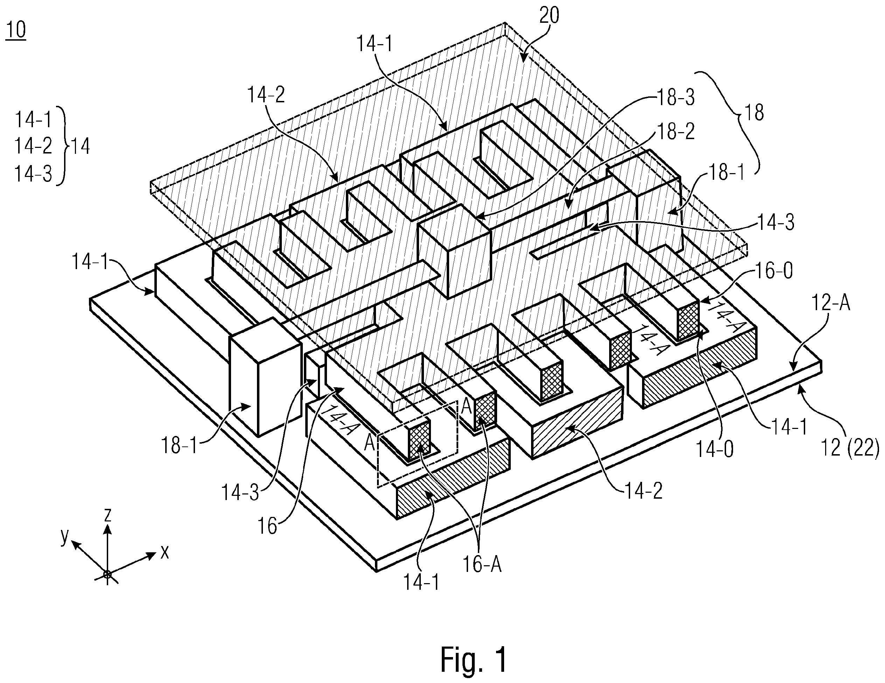

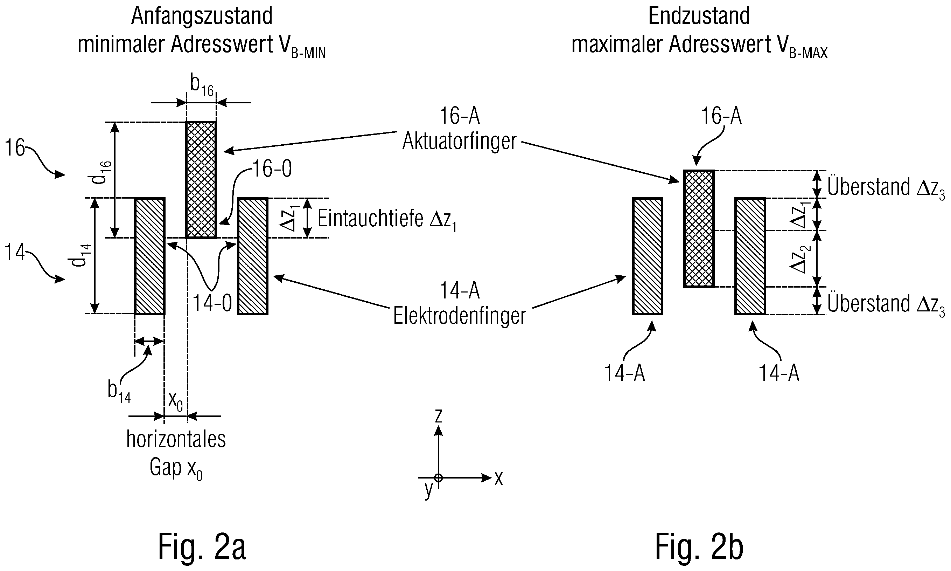

Im Folgenden wird anhand der Fig. 1 und 2a-b eine beispielhafte Ausgestaltung eines MEMS-Aktuators 10 gemäß einem Ausführungsbeispiel näher erläutert.

Fig. 1 zeigt eine schematische perspektivische Ansicht des MEMS-Aktuators 10 gemäß einem Ausführungsbeispiel, während die Fig. 2a-b jeweils eine schematische Teilquerschnittsansicht entlang einer Schnittlinie A-A in Fig. 1 und parallel zu der x-z-Ebene durch einen Abschnitt einer Teilelektrodenstruktur 14-1 der ersten Elektrodenstruktur 14 und einen gegenüberliegenden Abschnitt der zweiten Elektrodenstruktur 16 in einem Anfangszustand (Fig. 2a) und einem Endzustand (Fig. 2b) zeigen.

Der MEMS-Aktuator 10 umfasst ein Substrat 12, beispielsweise einen vollständigen Wafer bzw. Halbleiter-Wafer oder alternativ einen teilweise oder ganz vereinzelten Abschnitt des Wafers. Das Substrat 12 kann einen Hauptoberflächenbereich 12-A parallel zu der Substratebene (parallel zur X-Y-Ebene) ausbilden und sich zumindest teilweise in der Substratebene erstrecken. Die Substratebene ist beispielsweise parallel zu einer Hauptseite 12-A eines Wafers (nicht gezeigt in Fig. 1) angeordnet, die vereinfacht als Oberseite oder Unterseite bezeichnet werden kann, ohne dass diese Begriffe einschränkende Wirkung aufweisen sollen. Da Begriffe wie oben, unten, links, rechts, vorne und hinten basierend auf einer veränderten Orientierung des MEMS-Aktuators 10 im Raum veränderlich oder vertauschbar sind.

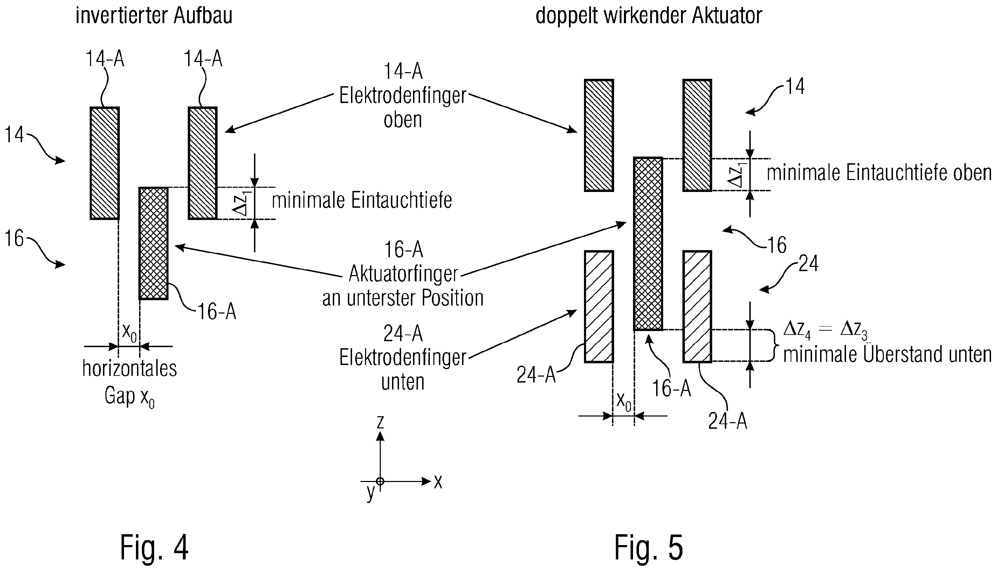

Der MEMS-Aktuator 10 umfasst ferner eine erste Elektrodenstruktur 14, die bezüglich des Substrats feststehend angeordnet ist. Die erste Elektrodenstruktur 14 weist eine Mehrzahl (z. B. n) von Teilelektrodenstrukturen 14-1, ..., 14-n auf, die jeweils eine Kantenstruktur 14-0 aufweisen und getrennt voneinander elektrisch ansteuerbar sind, d. h. beispielsweise mit einem elektrischen Ansteuersignal bzw. einer Ansteuerspannung versorgbar sind. Die erste Elektrodenstruktur 14 mit den Teilelektrodenstrukturen 14-1, ..., 14-n kann an bzw. direkt an dem Hauptoberflächenbereich 12-A des Substrats 12 angeordnet sein. Gemäß einem Ausführungsbeispiel kann die erste Elektrodenstruktur 14 beispielsweise mittels Abstandelementen (nicht gezeigt in Fig. 1) beabstandet von dem Hauptoberflächenbereich 12-A des Substrats 12 angeordnet sein, wobei diesbezüglich beispielsweise auf Fig. 4 und die zugehörige Beschreibung hingewiesen wird.

Der MEMS-Aktuator 10 umfasst ferner eine zweite Elektrodenstruktur 16 mit einer Kantenstruktur 16-0, wobei die zweite Elektrodenstruktur 16 mittels einer Federstruktur 18 auslenkbar mit dem Substrat 12 gekoppelt ist und mittels der ersten Elektrodenstruktur 14 elektronisch auslenkbar ist, um die Kantenstruktur 16-0 der zweiten Elektrodenstruktur 16 in eine diskrete Auslenkposition z einer Mehrzahl von möglichen, diskreten Auslenkpositionen z bezüglich der Kantenstruktur 14-0 der ersten Elektrodenstruktur 14 zu bewegen bzw. auszulenken.

Wie in Fig. 1 beispielhaft dargestellt ist, weist die erste Elektrodenstruktur 14 beispielsweise drei (n = 3) Teilelektrodenstrukturen 14-1, 14-2, 14-3 auf, wobei Abschnitte der Teilelektrodenstruktur 14-1 an den Eckbereichen der ersten Elektrodenstruktur 14 angeordnet ist, wobei Abschnitte der zweite Teilelektrodenstruktur 14-2 lateral (in x-Richtung) zwischen Abschnitten der ersten Teilelektrodenstruktur 14-1 angeordnet sind, und wobei Abschnitte der dritten Teilelektrodenstruktur 14-3 lateral (in y-Richtung) zwischen weiteren Abschnitten der ersten Teilelektrodenstruktur 14-1 angeordnet sind. Wie in Fig. 1 beispielhaft dargestellt ist, weist die erste Teilelektrodenstruktur 14-1 vier elektrisch miteinander verbundene Abschnitte auf, während die zweite Teilelektrodenstruktur 14-2 zwei elektrisch miteinander verbundene Abschnitte aufweist und die dritte Teilelektrodenstruktur 14-2 zwei elektrisch miteinander verbundene Abschnitte aufweist.

Die unterschiedlichen Teilelektrodenstrukturen 14-1, 14-2, 14-3 sind getrennt ansteuerbar ausgebildet, um basierend auf einer elektrischen Ansteuerspannung $V_S$ der einzelnen Teilelektrodenstrukturen 14-1, 14-2, 14-3 jeweils eine unterschiedliche, gleichgerichtete elektrostatische Kraft durch die unterschiedlichen Teilelektrodenstrukturen 14-1, 14-2, 14-3 auf die zweite Elektrodenstruktur 16 auszuüben und die zweite Elektrodenstruktur 16 in eine der diskreten Auslenkpositionen z auszulenken.

Die selektiv bzw. individuell ansteuerbaren Teilelektrodenstrukturen 14-1, 14-2, 14-3 der ersten Elektrodenstruktur 14 unterscheiden sich hinsichtlich ihrer geometrischen Ausgestaltung, z.B. in ihrer Größe, z.B. der Anzahl der Finger bzw. der Kantenlänge, und/oder dem horizontalen Abstand zu der auslenkbaren zweiten Elektrodenstruktur 16. Die selektiv ansteuerbaren Teilelektrodenstrukturen 14-1, 14-2, 14-3 der ersten Elektrodenstruktur 14 haben somit einen unterschiedlich starken Einfluss auf die Auslenkung der zweiten Elektrodenstruktur 16.

Die in Fig. 1 dargestellte Ausgestaltung der Teilelektrodenstrukturen 14-1, 14-2, 14-3 der ersten Elektrodenstruktur 14 ist aber nur als beispielhaft anzusehen, wobei sich entsprechend dem jeweiligen Anwendungsfall die Anzahl "n" und die geometrische Ausgestaltung und Anordnung der ansteuerbaren Teilelektrodenstrukturen 14-1, ..., 14-n der ersten Elektrodenstruktur 14 sowie die geometrische Ausgestaltung und Anordnung der jeweiligen Abschnitte der ansteuerbaren Teilelektrodenstrukturen 14-1, ..., 14-n von der Darstellung in Fig. 1 unterscheiden können. Die Anzahl n von Teilelektrodenstrukturen kann beispielsweise in einem Bereich von 2 - 8 (2, 3, 4, ..., 7, 8 oder auch darüber) liegen:

Bei dem MEMS-Aktuator 10 sind die gegenüberliegenden Abschnitte der Kantenstrukturen 14-0, 16-0 der ersten und zweiten Elektrodenstruktur 14, 16 mit einem lateralen bzw. horizontalen Abstand $x_0$ (in der x-y-Ebene) voneinander beabstandet (siehe auf Fig. 2a-b). Der laterale Abstand $x_0$ bezieht sich somit (in einer Draufsicht) auf lateral gegenüberliegende Abschnitte der Kantenstrukturen 14-0, 16-0 der ersten und zweiten Elektrodenstruktur 14, 16. Die einzelnen Teilelektrodenstrukturen 14-1, ..., 14-n der ersten Elektrodenstruktur 14 sind nun ausgebildet, um basierend auf einer elektrischen Ansteuerspannung $V_S$ eine unterschiedliche, gleichgerichtete elektrostatische Kraft auf die zweite Elektrodenstruktur 16 auszuüben und die zweite Elektrodenstruktur 16 in eine der diskreten Auslenkpositionen z auszulenken.

Bei der in Fig. 1 dargestellten Ausführungsform des MEMS-Aktuators 10 ist die zweite Elektrodenstruktur 16 translatorisch bezüglich der ersten Elektrodenstruktur 14 auslenkbar. Wie in Fig. 1 beispielhaft dargestellt ist, kann die Federstruktur 18 zwei Pfosten bzw. Substratfortsätze 18-1 aufweisen, wobei ein Federelement 18-2 zwischen den beiden Pfosten 18-1 angeordnet ist, d. h., zwischen den beiden Pfosten 18-1 eingespannt bzw. an denselben gelagert ist und somit eine beidseitig eingespanntes Federelement 18-2 bildet. An dem Federelement 18-2 ist nun ferner ein Verbindungselement 18-3 angeordnet, das mechanisch mit der zweiten Elektrodenstruktur 16 verbunden ist. Das Federelement 18-2 stellt eine Federkraft ein, die beispielsweise der elektrostatisch bewirkten Auslenkung der zweiten Elektrodenstruktur 16 vertikal (in -z-Richtung) zu der ersten Elektrodenstruktur 14 entgegenwirkt.

Ausführungsbeispiele beziehen sich somit auf mikromechanische Aktuatoren (MEMS-Aktuatoren) 10, die elektrostatisch z.B. mit einer Biasspannung $U_{BIAS}$ angesteuert werden und über eine rückstellende elastische Aufhängung 18 verfügen, die für eine statische Gleichgewichtsauslenkung eine entsprechende Gegenkraft aufbringt, um die zweite Elektrodenstruktur 16 in die Anfangsposition bzw. den Anfangszustand (Fig. 2a) zu bringen.

Der MEMS-Aktuator 10 kann ferner ein Funktionselement 20 aufweisen, das mittels des Verbindungselementes 18-3 auch mit der zweiten Elektrodenstruktur 16 mechanisch fest gekoppelt ist. Das Funktionselement 20 kann ein Element sein, dessen translatorische und/oder rotatorische Position durch die elektrostatische Auslenkung zwischen der ersten und zweiten Elektrodenstruktur 14, 16 eingestellt, gesteuert oder zumindest beeinflusst werden kann. Beispielsweise kann das Funktionselement 20 ein Mikrospiegel und/oder eine elektrisch leitfähige Struktur sein.

Gemäß einem Ausführungsbeispiel kann das Verbindungselement 18-3 an einem Flächenschwerpunkt des Funktionselements 20 mechanisch mit demselben gekoppelt sein, wobei das Verbindungselement 18-3 ferner an einem Flächenschwerpunkt der zweiten Elektrodenstruktur 16 mit derselben mechanisch gekoppelt sein kann. Diese symmetrische Anordnung ist nur beispielhaft anzusehen, wobei andere Konfiguration gewählt werden können, wie dies in nachfolgenden Ausführungsbeispielen noch dargestellt wird.

Wie in Fig. 1 ferner beispielhaft dargestellt ist, kann die Kantenstruktur 16-0 der zweiten Elektrodenstruktur 16 hinsichtlich einer Draufsicht (und parallel zu der x-y-Ebene) ineinandergreifend zu der Kantenstruktur 14-0 der ersten Elektrodenstruktur 14 ausgebildet sein. So kann die Kantenstruktur 14-0 der ersten Elektrodenstruktur 14 eine Finger- oder Kammstruktur (mit Fingerelementen 14-A, 16-A) aufweisen, wobei die Kantenstruktur 16-0 der zweiten Elektrodenstruktur 16 eine weitere gegenüberliegende Finger- oder Kammstruktur aufweisen kann.

In diesem Fall wird beispielsweise auch von einem "Kammantrieb" (engl. comb drive), der durch die erste und zweite Elektrodenstruktur 14, 16 gebildet ist, gesprochen. In diesem Zusammenhang wird aber darauf hingewiesen, dass der Begriff "Kammantrieb" nicht einschränkend zu verstehen ist, da auch für die erste und/oder zweite Elektrodenstruktur 14, 16 auch nur mit wenigen Finger- oder Kammelementen 14-A, 16-A eingesetzt werden können.

Ferner können gemäß dem vorliegenden Funktionsprinzip die erste und/oder zweite Elektrodenstruktur 14, 16 auch als Kantenelemente ohne Finger- oder Kammelemente nach den hier beschriebenen Grundlagen funktionieren. So kann beispielsweise die erste Elektrodenstruktur 14 in einer Draufsicht (und parallel zur x-y-Ebene) als eine umlaufende Struktur zu der zweiten Elektrodenstruktur 16 ausgebildet sein. Allgemein kann dann auch von einem elektrostatischen Kantenaktuator gesprochen werden, da die Aktuatorkraft proportional zu der Länge der sich gegenüberstehenden Kantenstrukturen 14-0, 16-0 der ersten und zweiten Elektrodenstruktur 14, 16 ist.

Soweit es die herstellbaren Strukturgrößen erlauben, sind daher eine Finger- oder Kammstruktur für die Kantenstruktur 14-0, 16-0 der ersten und zweiten Elektrodenstruktur 14, 16 effektiver einsetzbar, wobei in Fig. 1a gemäß einem Ausführungsbeispiel der MEMS-Aktuator 10 eine erste und zweite Elektrodenstruktur 14, 16 mit nur wenigen Fingerelementen 14-A, 16-A aufweist, so dass sich die resultierenden MEMS-Aktuatoren 10 in der Substratebene dicht anordnen lassen und Pixelgrößen von beispielsweise nur dem rund 8- bis 16-fachen der Minimalstrukturgröße aufweisen können. Als Minimalstrukturgröße oder minimale Strukturgröße wird im Allgemeinen der Wert der kleinsten Struktur bezeichnet, die zuverlässig fotolithografisch hergestellt werden kann.

In diesem Zusammenhang wird darauf hingewiesen, dass der Anfangszustand (mit einem minimalen Adresswert, d. h. einer minimalen Ansteuerspannung $V_S$) nicht einer kräftefreien Position der an der Federstruktur 18 angeordneten zweiten Elektrodenstruktur 16 zu entsprechen braucht, da beispielsweise die elektrische Ansteuerspannung $V_S$ ferner einen konstanten Anteil in Form einer elektrischen Vorspannung $V_{BIAS}$ aufweisen kann. Gemäß einem Ausführungsbeispiel kann die Ansteuerspannung $V_S$ also einen Vorspannungsanteil (eine Bias-Spannung) $V_{Bias}$ und einen Betriebsspannungsanteil $V_B$ aufweisen. Gemäß einem weiteren Ausführungsbeispiel kann die Ansteuerspannung $V_S$ nur den Betriebsspannungsanteil $V_B$ aufweisen.

Gemäß einem Ausführungsbeispiel kann der MEMS-Aktuator 10 ferner eine Ansteuereinrichtung 22 zum Bereitstellen der Ansteuerspannung $V_S$ zwischen der ersten und zweiten Elektrodenstruktur 14, 16 des MEMS-Aktuators 10 aufweisen. Dabei kann die Ansteuereinrichtung 22 ausgebildet sein, um zumindest eine Teilmenge oder alle der Teilelektrodenstrukturen 14-1, ..., 14-n der ersten Elektrodenstruktur 14 des MEMS-Aktuators 10 mit einem diskreten Spannungswert der Ansteuerspannung $V_S$ selektiv anzusteuern, um basierend auf der ausgewählten Teilmenge der Teilelektrodenstrukturen 14-1, ..., 14-n eine resultierende elektrostatische Kraft auf die zweite Elektrodenstruktur 16 mit einer entsprechenden Änderung der diskreten Auslenkposition z der Kantenstruktur 16-0 der zweiten Elektrodenstruktur 16 bezüglich der Kantenstruktur 14-0 der ersten Elektrodenstruktur 14 zu erhalten.

Gemäß einem Ausführungsbeispiel kann die elektrische Ansteuerspannung $V_S$, die von der Ansteuereinrichtung 22 bereitgestellt wird, eine Mehrzahl von unterschiedlichen, diskreten Spannungswerten (Signalpegeln) $V_{Si}$ aufweisen, um eine diskrete Ansteuerung des MEMS-Aktuators 10 bereitzustellen, wobei basierend auf den unterschiedlichen diskreten Spannungswerten $V_{Si}$ der elektrischen Ansteuerspannung $V_S$ die Kantenstruktur 16-0 der zweiten Elektrodenstruktur 16 in unterschiedliche, diskrete, vertikal beabstandete Auslenkpositionen z bezüglich der Kantenstruktur 14-0 der ersten Elektrodenstruktur 14 auslenkbar ist. Dabei können beispielsweise mehrere unterschiedliche, diskrete Spannungswerte $V_{Si}$ mit i = 2, 3 oder 4 (oder auch mehr) eingesetzt werden. So können unterschiedliche Teilelektrodenstrukturen 14-1, ..., 14-n der ersten Elektrodenstruktur auch 14 jeweils mit einem unterschiedlichen diskreten Spannungswert $V_{Si}$ der elektrischen Ansteuerspannung $V_S$ angesteuert werden.

Gemäß einem Ausführungsbeispiel kann die elektrische Ansteuerspannung $V_S$, die von der Ansteuereinrichtung 22 bereitgestellt wird, zwei unterschiedliche, diskrete Spannungswerte $V_{S1}$, $V_{S2}$ aufweisen, um eine digitale Ansteuerung des MEMS-Aktuators 10 bereitzustellen.

Die Ansteuereinrichtung 22 kann beispielsweise in das Halbleitermaterial des Substrats 12 integriert sein oder auch extern zu dem Substrat angeordnet sein und elektrisch mit den Teilelektrodenstrukturen 14-1, ..., 14-n der ersten Elektrodenstruktur 14 und der zweiten Elektrodenstruktur 16 verbunden sein.

Gemäß einem Ausführungsbeispiel kann die erste Elektrodenstruktur also "n" Teilelektrodenstrukturen aufweisen, die bei einem diskreten Spannungswert der elektrischen Ansteuerspannung eine, z.B. um einen vorgegebenen Faktor unterschiedliche, gleichgerichtete elektrostatische Kraft auf die zweite Elektrodenstruktur 16 ausüben. So kann jede der "n" Teilelektrodenstrukturen einer unterschiedlichen Bit-Position eines Bit-Worts zugeordnet werden, wobei die jeweilige Teilelektrodenstruktur einer umso höherwertigen Bit-Bitposition des Bit-Worts zugeordnet ist, je größer bei einer elektrischen Anregung die elektrostatische Kraft dieser Teilelektrodenstruktur 14-n auf die zweite Elektrodenstruktur 16 ist, und wobei der Wert des jeweiligen Bits des Bit-Worts den Aktivierungszustand der zugeordneten Teilelektrodenstruktur widergibt. Somit kann ein n-Bit-Wort verwendet werden, um die "n" Teilelektrodenstrukturen 14-1, ..., 14-n der ersten Elektrodenstruktur anzusteuern.

Gemäß einem Ausführungsbeispiel können die Teilelektrodenstrukturen 14-1, ..., 14-n so gestaltet sein, dass ihr Einfluss auf die Auslenkung sich jeweils um den Faktor 2 unterscheidet, z.B. durch um den Faktor 2 unterschiedliche Fingeranzahl bzw. Kantenlängen bei konstantem horizontalem Gap, oder durch gleiche Kantenlängen bei um den Faktor √2 abgestufte horizontale Gaps.

Gemäß einem weiteren Ausführungsbeispiel können die Teilelektrodenstrukturen 14-1, ..., 14-n sowohl in der Kantenlänge als auch im horizontalen Gap abgestuft sein, wobei dann einer der Faktoren (pro bit) gewählt werden kann und der andere sich aus der Forderung nach doppeltem Einfluss ergibt. Dann können die die Teilelektrodenstrukturen 14-1, ..., 14-n einfach direkt den verschiedenen Bits des Adresswertes zugeordnet werden.

Diese Implementierungen und Auslegungen sind nur als beispielhaft anzusehen und können je nach Anwendungsgebiet des MEMS-Aktuators 10 variieren.

Fig. 2a zeigt nun eine schematische Teilquerschnittsansicht entlang einer Schnittlinie A-A in Fig. 1 und parallel zur x-z-Ebene durch einen Abschnitt einer Teilelektrodenstruktur 14-1 der ersten Elektrodenstruktur 14 und einen gegenüberliegenden Abschnitt der zweiten Elektrodenstruktur 16 in einem Anfangszustand. In dem Anfangszustand kann die Betriebsspannung $V_B$ (d. h. der variable Anteil der Ansteuerspannung $V_S$) einen minimalen Betriebsspannungswert $V_{B-MIN}$ aufweisen. Für eine Anzahl n = 3 von Teilelektrodenstrukturen 14-1, ..., 14-n der ersten Elektrodenstruktur kann somit ein minimaler Adresswert vorliegen, der einem n-Bit-Wort (hier ein 3-Bit-Wort) mit dem Bit-Wert "000" zugeordnet werden kann.

Fig. 2b zeigt nun eine schematische Teilquerschnittsansicht entlang einer Schnittlinie A-A in Fig. 1 und parallel zur x-z-Ebene durch einen Abschnitt einer Teilelektrodenstruktur 14-1 der ersten Elektrodenstruktur 14 und einen gegenüberliegenden Abschnitt der zweiten Elektrodenstruktur 16 in einem Endzustand. In dem Endzustand kann die Betriebsspannung $V_B$ (d. h. der variable Anteil der Ansteuerspannung $V_S$) einen maximalen Betriebsspannungswert $V_{B-MAX}$ aufweisen. Für eine Anzahl n = 3 von Teilelektrodenstrukturen 14-1, ..., 14-n der ersten Elektrodenstruktur kann somit ein maximaler Adresswert vorliegen, der einem n-Bit-Wort (hier ein 3-Bit-Wort) mit dem Bit-Wert "111" zugeordnet werden kann.

Anhand der Darstellung in Fig. 2a-b der Abschnitte bzw. Fingerelemente 14-A, 16-A der Kantenstruktur 14-0, 16-0 der ersten und zweiten Elektrodenstruktur 14, 16 werden nun sowohl die relativen Positionen und Auslenkungswege der Kantenstrukturen 14-0, 16-0 der ersten und zweiten Elektrodenstruktur 14, 16 des MEMS-Aktuators 10 zueinander als auch typische Abmessungen der Kantenstrukturen 14-0, 16-0 der ersten und zweiten Elektrodenstruktur 14, 16 erläutert.

So sind in Fig. 2a-b zwei einzelne Fingerelemente 16-A der Kantenstruktur 16-0 der zweiten Elektrodenstruktur 16 und ein sich relativ dazu bewegendes Fingerelement 14-A der Kantenstruktur 14-0 einer der Teilelektrodenstrukturen 14-1, ..., 14-n der ersten Elektrodenstruktur 14 dargestellt. Die in Fig. 2a-b dargestellte Anordnung der Fingerelemente 14-A, 16-A der Kantenstrukturen 14-0, 16-0 ist (zumindest abschnittsweise) periodisch fortsetzbar, um die umlaufenden Kantenstrukturen 14-0 und 16-0 der ersten und zweiten Elektrodenstruktur 14, 16 zu bilden.

Wie in Fig. 2a-b beispielhaft dargestellt ist, weisen die Fingerelemente 14-0 der ersten Elektrodenstruktur 14 eine vertikale Dicke $d_{14}$ (in z-Richtung) und eine laterale Breite $b_{14}$ (in der x-y-Ebene) auf. Die Fingerelemente 16-A der zweiten Elektrodenstruktur 16 weisen eine vertikale Dicke $d_{16}$ und eine laterale (horizontale) Breite $b_{16}$ auf. Wie bereits vorhergehend erläutert wurde, stellt Fig. 2a einen Anfangszustand bzw. Grundzustand in einer minimalen Auslenkposition $\Delta z_1$ (minimale Eintauchtiefe oder Mindesteintauchtiefe) des MEMS-Aktuators 10 dar, während Fig. 2b einen Endzustand in einer maximalen Auslenkposition $\Delta z_2$ (= maximale Eintauchtiefe) mit einem verbleibenden vertikalen Überstand $\Delta z_3$ zwischen der ersten und zweiten Elektrodenstruktur 14, 16 darstellt. Die minimale und maximale Auslenkposition geben einen maximalen Auslenkungsweg $\Delta z_2$ an, wobei sich die diskrete Auslenkposition z an einer vertikalen Position (parallel zur z-Richtung) entlang des maximalen Auslenkungswegs $\Delta z_2$ befindet.

Gemäß einem Ausführungsbeispiel kann der MEMS-Aktuator 10 ein Mikrospiegelelement als das Funktionselement 20 aufweisen, das mit der zweiten Elektrodenstruktur 16 gekoppelt ist. Bei Anwendungen für sichtbares Licht können beispielsweise für eine Minimalstruktur folgende Abmessungen des MEMS-Aktuators 10 vorliegen: $x_0 \approx 200nm$, $d_{14} = d_{16} \approx 1000nm$, $b_{14} = b_{16} \approx 400nm$. Diese Werte sind nur als beispielhaft anzusehen und können je nach Anwendungsgebiet des MEMS-Aktuators 10 variieren.

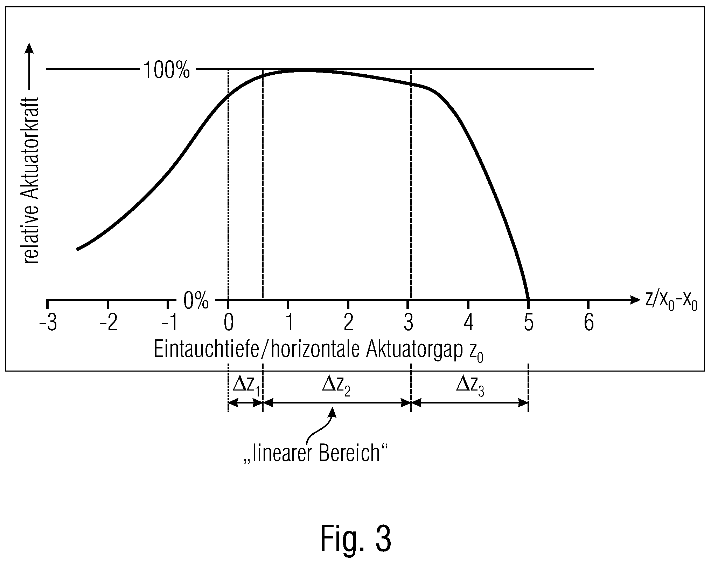

Fig. 3 zeigt nun einen qualitativen Verlauf der (relativen) Aktuatorkraft bei fester Ansteuerspannung $V_S$ gegenüber der Eintauchtiefe bzw. der diskreten Auslenkpositionen z der zweiten Elektrodenstruktur 16 bzgl. der ersten Elektrodenstruktur 14 beispielhaft für einen Kammantrieb gemäß einem Ausführungsbeispiel. Bei dem Ausführungsbeispiel weisen die Fingerelemente (= Kämme) 14-A, 16-A eine vertikale Dicke (Höhe) $d_{14}$, $d_{16}$ auf weisen, die dem 5-fachen Wert des lateralen Abstands (= horizontalen Gap) $x_0$ entspricht. Somit stimmen bei dem Ausführungsbeispiel von Fig. 3 in dem Punkt z = 0 die Ebene der Unterkante der Fingerelemente 16-A der zweiten Elektrodenstruktur 16 mit der Ebene der Oberkante der Fingerelemente 46-A der ersten Elektrodenstruktur 14 überein, während der Punkt z = 5 einer vollständigen vertikalen Überlappung der Fingerelemente 14-A, 16-A der ersten und zweiten Elektrodenstruktur 14, 16 entspricht. Negative Werte der Eintauchtiefe entsprechen einem vertikalen Abstand zwischen der ersten und zweiten Elektrodenstruktur 14, 16. Wie aus Fig. 3 deutlich wird, ist die relative Aktuatorkraft für über einen weiten Bereich (z.B. zwischen dem 0,5-fachen Wert und dem 2,5- oder 3-fachen Werte des lateralen Abstands $x_0$

fast unabhängig von der Auslenkposition z.

Gemäß einem Ausführungsbeispiel sind die erste und zweite Elektrodenstruktur 14, 16 bzw. der Kantenstrukturen 14-0, 16-0 in einer Ebene (x-y-Ebene) parallel zu dem Substrat 12 um den lateralen Abstand $x_0$ beabstandet, wobei die zweite Elektrodenstruktur 16 in der minimalen Auslenkposition bzgl. der ersten Elektrodenstruktur eine erste Eintauchtiefe aufweist, wobei die erste Eintauchtiefe bzw. erste Auslenkposition $\Delta z_1$ beispielsweise zumindest den -0,25-fachen, 0-fachen oder 0,5-fachen Wert des lateralen Abstands $x_0$ aufweist oder wobei die erste Eintauchtiefe zwischen dem -0,25-fachen, 0-fachen oder 0,5-fachen Wert und dem 1,5-fachen Wert des lateralen Abstands $x_0$ liegt.

In Fig. 3 ist beispielhaft der 0,5-fache Wert des lateralen Abstands $x_0$ für die erste Eintauchtiefe $\Delta z_1$ angegeben. Die erste Eintauchtiefe $\Delta z_1$ bei minimaler Auslenkung (in der Anfangsposition) kann also für eine möglichst gute Linearität der relativen Aktuatorkraft mindestens halb so groß sein wie der horizontale Abstand $x_0$ der gegenüberliegenden Abschnitte der wirksamen Kantenstrukturen 14-0, 16-0 der ersten und zweiten Elektrodenstruktur 14, 16.

Falls eine geringere Genauigkeit mit geringeren Anforderungen an die Linearität der relativen Aktuatorkraft tolerierbar ist, kann die erste Eintauchtiefe $\Delta z_1$ bei minimaler Auslenkung i.W. nur größer Null sein, mit $\Delta z_1 >$ 0. Falls eine noch geringere Genauigkeit mit geringeren Anforderungen an die Linearität der relativen Aktuatorkraft tolerierbar ist, kann die Eintauchtiefe bzw. erste Auslenkposition $\Delta z_1$ bei minimaler Auslenkung i.W. einen negativen Wert aufweisen, ein vertikaler Anfangsabstand $\Delta z_1$ von bis zu einem Viertel des horizontalen Abstands $x_0$, mit $\Delta z_1 \geq -1/4\ x_0$, zugelassen werden kann. Diese Implementierung kann ggf. attraktiv sein, da es auch für Fälle ohne Biasspannung $V_{BIAS}$ ein relative einfaches Fertigungsverfahren erlaubt.

Gemäß einem Ausführungsbeispiel sind ferner in einer maximalen Eintauch- bzw. Auslenkposition $\Delta z_2$ der zweiten Elektrodenstruktur 16 bzgl. der ersten Elektrodenstruktur 14 ein vertikaler Überstand oder Versatz $\Delta z_3$ zwischen der ersten und zweiten Elektrodenstruktur 14, 16 zumindest den 1-fachen, 1,5-fachen oder 2-fachen Wert des lateralen Abstands $x_0$ der gegenüberliegenden Abschnitte der wirksamen Kantenstrukturen 14-0, 16-0 der ersten und zweiten Elektrodenstruktur 14, 16, um bis zur maximalen Auslenkung (in der Endposition) $\Delta z_2$ eine möglichst gute Linearität der relativen Aktuatorkraft zu erhalten.

In Fig. 3 ist beispielhaft der 2-fache Wert des lateralen Abstands $x_0$ für den Überstand (= zweite Eintauchtiefe) $\Delta z_3$ angegeben. Der Überstand $\Delta z_3$ bei maximaler Auslenkung (in der Endposition) kann also für eine möglichst gute Linearität der relativen Aktuatorkraft mindestens doppelt so groß sein wie der horizontale Abstand $x_0$ der gegenüberliegenden Abschnitte der wirksamen Kantenstrukturen 14-0, 16-0 der ersten und zweiten Elektrodenstruktur 14, 16.

Falls eine geringere Genauigkeit mit geringeren Anforderungen an die Linearität der relativen Aktuatorkraft tolerierbar ist, kann die zweite Eintauchtiefe $z_2$ bei maximaler Auslenkung mindestens größer dem 1,5-fachen Wert des horizontalen Abstands $x_0$ sein.

Falls eine noch geringere Genauigkeit mit geringeren Anforderungen an die Linearität der relativen Aktuatorkraft tolerierbar ist, kann für die zweite Eintauchtiefe bzw. Auslenkposition $z_2$ bei maximaler Auslenkung ein Überstand von mindestens dem horizontalen Abstand $x_0$ ausreichend sein.

Gemäß Ausführungsbeispielen kann also ein digital angesteuerter, mehrstufiger, elektrostatischer MEMS-Aktuator 10 bereitgestellt, mit dem eine möglichst gleichmäßig abgestufte Auslenkung erreicht werden kann, wobei auch bei sehr kleinen, dicht gepackten MEMS-Aktuatoren 10 die maximale Auslenkung und die Aktuatorkraft möglichst groß sein und ein Übersprechen zwischen den Elektroden bzw. Elektrodenstrukturen 14, 16 eines Pixels wie auch denen der Nachbarpixel möglichst klein sein.

Gemäß Ausführungsbeispielen kann der MEMS-Aktuator 10 mit einem Kammantrieb eingesetzt werden, wobei die erste Elektrodenstruktur 14, die bezüglich des Substrats feststehend angeordnet ist, eine Mehrzahl (n) von Teilelektrodenstrukturen 14-1, ..., 14-n aufweist, die eine Kantenstruktur 14-0 der ersten Elektrodenstruktur 14 bilden und getrennt voneinander, elektrisch ansteuerbar sind. Die Teilelektrodenstrukturen 14-1, ..., 14-n unterscheiden sich in ihrer Größe, wie z.B. Anzahl der Finger bzw. Kantenlänge, und/oder dem horizontalen Abstand $x_0$ zur beweglichen zweiten Elektrodenstruktur und haben so unterschiedlich starken Einfluss auf die Auslenkung z.

Mit Kammantrieben lässt sich im Bereich $\Delta z_3$ eine von der Auslenkung weitgehend unabhängige Kraft erzeugen, wie dies im vorhergehenden anhand von Fig. 3 erläutert wurde. Dies sorgt dafür, dass die Abstufung gleichmäßig wird, wenn die anhand von Fig. 3 erläuterten Bedingungen für die Eintauchtiefe $\Delta z_1$ und den Überstand $\Delta z_3$ eingehalten werden.

Daraus ergibt sich, das die Fingerelemente (= Kämme) 14-A, 16-A der ersten und zweiten Elektrodenstruktur eine vertikale Dicke (Höhe) $d_{14}$, $d_{16}$ aufweisen, die der Summe aus Eintauchtiefe $\Delta z_1$, linearem Bereich $\Delta z_2$ und Überstand $\Delta z_3$ entspricht, mit $d_{14} = \Delta z_1 + \Delta z_2 + \Delta z_3$ oder $d_{16} = \Delta z_1 + \Delta z_2 + \Delta z_3$. Gemäß einem Ausführungsbeispiel kann die vertikale Dicke (Höhe) $d_{14}$, $d_{16}$ der Fingerelemente (= Kämme) 14-A, 16-A der ersten und zweiten Elektrodenstruktur 14, 16 gleich sein, mit $d_{14} = d_{16}$. Die vertikale Dicke (Höhe) $d_{14}$, $d_{16}$ kann auch z.B. herstellungsbedingt unterschiedlich sein, mit $d_{14} \neq d_{16}$.

Diesbezüglich wird darauf hingewiesen, dass die Eintauchtiefe bzw. erste Auslenkposition $\Delta z_1$ bei minimaler Auslenkung auch einen negativen Wert aufweisen kann, z.B. mit $\Delta z_1 \geq -1/4\, x_0$.

Die gewünschte anfängliche Eintauchtiefe $\Delta z_1$ der mechanisch verbundenen Fingerelemente bzw. Kämme 14-A, 16-A der ersten und zweiten Elektrodenstruktur 14, 16 in einander kann einerseits direkt bei der Fertigung des MEMS-Aktuators 10 gebildet werden. Oft ist es jedoch einfacher, die Fingerelemente 14-A, 16-A in völlig getrennten Fertigungsebenen herzustellen, ggf. sogar mit einer (dünnen) Trennschicht dazwischen. Die geforderte Eintauchtiefe $\Delta z_1$ der Anfangslage kann dann durch Anlegen der Biasspannung $V_{BIAS}$ erreicht werden. Ist dies nicht gewünscht, kann die minimale Eintauchtiefe bzw. Auslenkposition $\Delta z_1$ auch durch andere Maßnahmen erreicht werden, z.B. durch einen definierten Stressgradient in der Federebene, oder durch mechanische Auslenkung während des Aufbaus in ein Gehäuse (nicht gezeigt).

In diesem Zusammenhang wird nochmals darauf hingewiesen, dass der Begriff "Kammantrieb" (comb drive) hier (gerade mit Hinblick auf sehr kleine Pixel 10) sehr allgemein verstanden werden soll, da auch Elektrodenstrukturen 14, 16 mit nur wenigen Fingerelementen 14-A, 16-A oder auch Elektrodenstrukturen 14, 16 ganz ohne Fingerelemente nach den gleichen Grundlagen funktionieren.

So können gemäß dem vorliegenden Funktionsprinzip die erste und/oder zweite Elektrodenstruktur 14, 16 als Kantenelemente ohne Finger- oder Kammelemente eingesetzt werden, wobei die erste und zweite Elektrodenstruktur 14, 16 gleichermaßen nach den hier beschriebenen Grundlagen funktionieren. So kann beispielsweise die erste Elektrodenstruktur 14 in einer Draufsicht (parallel zur x-y-Ebene) als eine umlaufende Struktur zu der zweiten Elektrodenstruktur 16 ausgebildet sein. Auch die Teilelektrodenstruktur 14-3 für das Bit "0" in Fig. 1 ist in diesem Sinne also ein Kammantrieb.

Allgemein kann dann auch von einem elektrostatischen Kantenaktuator gesprochen werden, da die Aktuatorkraft proportional zu der Länge der sich gegenüberstehenden Kantenstrukturen 14-1, 16-1 der ersten und zweiten Elektrodenstruktur 14, 16 ist. Das Vorsehen von Fingerelementen 14-A, 16-A kann weitere Vorteil bereitstellen, soweit es die herstellbaren (minimalen) Strukturgrößen erlauben.

Die Fig. 1 und 2a-b zeigen jeweils Fingerelemente 14-A, 16-A, die an ihren Enden in der gleichen Ebene zu Kämmen verbunden sind. Alternativ könnten die Fingerelemente 14-A, 16-A an ihrer Ober- bzw. Unterseite mit einander verbunden sein. In diesem Fall würde auch das verbindende Element den gegenüberliegenden Kamm anziehen, was wieder zu einer auslenkungsabhängigen Kraft führen würde und damit die Gleichmäßigkeit der Auslenkungsabstufung negativ beeinflusst. So liefern lateral verbundene Kämme gute Eigenschaften. Sollen in der Vertikalen verbundene Kämme genutzt werden, sollte die Höhe $d_{14}$, $d_{16}$ der Fingerelemente 14-A, 16-A und der oben geforderte Überstand $\Delta z_1$ um mindestens einen Abstand zweier Finger desselben Kamms erhöht werden, um die Nachteile gering zu halten.

Gemäß Ausführungsbeispielen ist das elektrostatische Feld ist bei Kammantrieben durch den kleinen Elektrodenabstand $x_0$ räumlich eng um die Elektrodenfinger 14-A, 16-A begrenzt. Dies sorgt für Aktuatorkräfte, die im Vergleich zu einem Plattenaktuator in der gleichen Pixelfläche wesentlich größer ausfallen können, auch wenn bei fertigungsbedingter gegebener Minimalgröße der Strukturen nur einige wenige Finger möglich sind. Allein dies ist bereits ein entscheidender Vorteil, da damit stärkere Federn und ein schnelleres Ansprechen des Aktuators möglich sind. Oberflächen-Mikromechanik erlaubt dabei wesentlich feinere Strukturen im Vergleich zur Bulk-Mikromechanik und ist daher bevorzugt. Dazu erlaubt der Kammantrieb ein sehr geringes Übersprechen zwischen den Elektroden desselben, wie auch des Nachbaraktuators.

Da sich der Hauptanteil des elektrischen Feldes zwischen den Fingerelementen 14-A und 16-A befindet, ist der Bereich hoher Feldstärken auf einen kleinen Raumbereich konzentriert. Die geringe Feldstärke des elektrischen Feldes im Außenraum ergibt ein geringes Übersprechen zu benachbarten MEMS-Aktuatoren 10.

Fig. 4 eine schematische Teilquerschnittsansicht durch einen Abschnitt der Kantenstruktur 14-0 der ersten Elektrodenstruktur 14 und einen gegenüberliegenden Abschnitt der Kantenstruktur 16-0 der zweiten Elektrodenstruktur 16 des MEMS-Aktuators 10 mit invertiertem Aufbau gemäß einem weiteren Ausführungsbeispiel.

Der MEMS-Aktuator 10 umfasst wieder die erste Elektrodenstruktur 14 mit einer Kantenstruktur 14-0, wobei die erste Elektrodenstruktur 14 mit der Kantenstruktur 14-0 bezüglich des Substrats 12 feststehend angeordnet ist. Die erste Elektrodenstruktur 14 mit der Kantenstruktur 14-0 ist mittels Abstandselementen (nicht gezeigt in Fig. 4)beabstandet von dem Hauptoberflächenbereich 12-A des Substrats 12 angeordnet. Die Abstandselemente (Pfosten) können Teil der ersten Elektrodenstruktur 14 und/oder des Substrats 12 sein.

Der MEMS-Aktuator 10 weist eine oben-liegende ersten Elektrodenstruktur (Stator) 14 mit den Fingerelementen (Statorfingern) 14-A der Kantenstruktur 14-0 auf, wobei die zweite Elektrodenstruktur (Aktor) 16 mit den Fingerelement (Aktorfinger) 16-0 der Kantenstruktur 16-0 (in der Ruheposition) vertikal zwischen der ersten Elektrodenstruktur 14 und dem Substrat 12 angeordnet ist.

Der laterale Abstand $x_0$ bezieht sich (in einer Draufsicht) wieder auf lateral gegenüberliegende Abschnitte der Kantenstrukturen 14-0, 16-0 der ersten und zweiten Elektrodenstruktur 14, 16, wobei Fig. 4 einen Anfangszustand bzw. Grundzustand in einer minimalen Auslenkposition $\Delta z_1$ (minimale Eintauchtiefe) des MEMS-Aktuators 10 darstellt.

Der MEMS-Aktuator 10 kann ferner eine leitfähige Grundplatte (nicht gezeigt in Fig. 4) zur Abschirmung des Einflusses der darunter liegenden Elektronik (nicht gezeigt) aufweisen. Die leitfähige Grundplatte kann als Teil des Substrats 12 ausgebildet sein. Anders als in den obigen Ausführungsbeispielen kann es vorteilhaft sein, die feste Elektrodenstruktur 14 (den Stator) vertikal oberhalb der beweglichen Elektrodenstruktur 16 anzuordnen, also auf der dem Substrat 12 abgewandten Seite.

Fig. 4 zeigt somit ein weiteres Beispiel für einen MEMS-Aktuator 10 mit nur wenigen Fingerelementen 14-A, 16-A, die sich in der Substratebene oder parallel zu der Substratebene dicht anordnen lassen und Abmessungen für den MEMS-Aktuator 10 (= Pixelgrößen) von nur rund dem rund acht- bis sechzehnfachen der Minimalstrukturgröße aufweisen können.

Fig. 5 zeigt eine schematische Teilquerschnittsansicht durch einen Teil eines MEMS-Aktuators 10 gemäß einem weiteren Ausführungsbeispiel, wobei der MEMS-Aktuator 10 als ein doppelt wirkender Aktuator ausgebildet ist.

Gemäß einem Ausführungsbeispiel kann der MEMS-Aktuator 10 eine dritte Elektrodenstruktur 24 aufweisen, die bezüglich des Substrats 12 feststehend angeordnet ist, wobei die zweite Elektrodenstruktur 16 (z.B. symmetrisch) zwischen der ersten und dritten Elektrodenstruktur 14, 24 angeordnet und auslenkbar ist. Dabei ist die zweite Elektrodenstruktur 16 mittels der dritten Elektrodenstruktur 24 elektrostatisch auslenkbar, um die Kantenstruktur 16-0 der zweiten Elektrodenstruktur 16 in eine weitere diskrete Auslenkposition $z_3$ zu bewegen. Die erste und dritte Elektrodenstruktur 14, 24 sind ausgebildet, um bei einer elektrischen Anregung eine entgegengesetzte elektrostatische Kraft auf die zweite Elektrodenstruktur 16 auszuüben.

Gemäß einem Ausführungsbeispiel kann die dritte Elektrodenstruktur 24 eine Teilelektrodenstrukturen 24 oder auch eine Mehrzahl von Teilelektrodenstrukturen 24-m (nicht gezeigt in Fig. 5) aufweisen, die jeweils eine Kantenstruktur 24-0 aufweisen und getrennt voneinander elektrisch ansteuerbar sind. Dabei können die einzelnen Teilelektrodenstrukturen 24-m der dritten Elektrodenstruktur 24 ausgebildet sein, um bei einer elektrischen Anregung eine unterschiedliche, gleichgerichtete elektrostatische Kraft auf die zweite Elektrodenstruktur 16 auszuüben.

Gemäß einem Ausführungsbeispiel kann also auch die dritte Elektrodenstruktur eine Mehrzahl "m" von Teilelektrodenstrukturen 24-m (nicht gezeigt in Fig. 5) aufweisen, die bei einem diskreten Spannungswert der elektrischen Ansteuerspannung $V_S$ eine, z.B. um einen vorgegebenen Faktor unterschiedliche, gleichgerichtete elektrostatische Kraft auf die zweite Elektrodenstruktur 16 ausüben. So kann jede der "m" Teilelektrodenstrukturen einer unterschiedlichen Bit-Position eines Bit-Worts zugeordnet werden, wobei die jeweilige Teilelektrodenstruktur einer umso höherwertigen Bit-Bitposition des Bit-Worts zugeordnet ist, je größer bei einer elektrischen Anregung die elektrostatische Kraft dieser Teilelektrodenstruktur 14-n auf die zweite Elektrodenstruktur 16 ist, und wobei der Wert des jeweiligen Bits des Bit-Worts den Aktivierungszustand der zugeordneten Teilelektrodenstruktur widergibt. Somit kann ein m-Bit-Wort verwendet werden, um die "m" Teilelektrodenstrukturen 24-1, ..., 24-n der dritten Elektrodenstruktur 24 anzusteuern.

Gemäß einem Ausführungsbeispiel können die zweite und dritte Elektrodenstruktur 16, 24 in einer Draufsicht (x-y-Ebene) parallel zu dem Substrat 12 um den lateralen Abstand $x'_0$ beabstandet sind, wobei die zweite Elektrodenstruktur 16 in der minimalen Auslenkposition in der dritten Elektrodenstruktur 24 einen Überstand $\Delta z_4$ (z.B. $\Delta z_4 = \Delta z_3$) aufweist, wobei der vertikale Überstand $\Delta z_4$ zwischen der zweiten und dritten Elektrodenstruktur 16, 24 zumindest den 1-fachen, 1,5-fachen oder 2-fachen Wert des lateralen Abstand $x_0$ aufweist, und wobei die Eintauchtiefe bzw. Auslenkposition $\Delta z_1$ der zweiten Elektrodenstruktur 16 in der ersten Elektrodenstruktur 14 zwischen dem -0,25-fachen (= Abstand), 0-fachen (= bündig) oder 0,5-fachen Wert und dem 1,5-fachen Wert des lateralen Abstands $x_0$ beträgt.

In der maximalen Auslenkposition (nicht gezeigt in Fig. 5) weist die zweite Elektrodenstruktur 16 in der ersten Elektrodenstruktur 24 den Überstand $\Delta z_3$ auf, wobei die zweite Elektrodenstruktur 16 die Eintauchtiefe $\Delta z_1$ in der dritten Elektrodenstruktur 24 aufweist.

In Fig. 5 sind beispielhaft zwei einzelne Fingerelemente 14-A der Kantenstruktur 14-0 der ersten Elektrodenstruktur 14 und zwei einzelne Fingerelemente 24-A der Kantenstruktur 24-0 der dritten Elektrodenstruktur 24 sowie ein sich relativ dazu bewegendes Fingerelement 16-A der Kantenstruktur 16-0 der zweiten Elektrodenstruktur 16 dargestellt. Die in Fig. 5 dargestellte Anordnung aus Fingerelementen 14-A, 16-A, 24-A der Kantenstrukturen 14-0, 16-0, 24-0 ist (zumindest abschnittsweise) periodisch fortsetzbar, um die umlaufenden Kantenstrukturen 14-0, 16-0, 24-0 der ersten, zweiten und dritten Elektrodenstruktur 14, 16, 24 zu bilden.

Bezüglich der geometrischen Anordnung der ersten und zweiten Elektrodenstruktur 14, 16 wird auf die Ausführungen zu Fig. 1 und 2a-b verwiesen, die hier gleichermaßen anwendbar sind.

Die obigen Ausführungen zu dem MEMS-Aktuator 10 von Fig. 5 machen somit deutlich, dass das vorliegende Konzept auch bei doppelt wirkenden Aktuatoren vorteilhaft eingesetzt werden kann, bei denen die bewegliche zweite Elektrodenstruktur 16 in beiden Richtungen (also 'oberhalb' und 'unterhalb' bzgl. der z-Richtung) festen Elektrodenstrukturen 14, 24 gegenüber steht. Dadurch kann jede Elektrodenebene, d.h. die erste und dritte Elektrodenstruktur 14, 24, ggf. nur für einen Teil der Adressbits des Bit-Worts des Ansteuersignals $V_S$ ausgelegt sein, wodurch das System, d.h. der MEMS-Aktuator 10, bei begrenzter Strukturauflösung nochmals stark verbesserte Eigenschaften aufweisen kann. So kann man z.B. das höchstwertige Bit durch viele Elektrodenfinger 24-A der dritten Elektrodenstruktur 24 oberhalb der beweglichen Elektrodenstruktur (des Aktuatorkamms) 16 realisieren, die anderen Bits des Bit-Worts durch entsprechend kleinere Fingergruppen, d.h. die Teilelektrodenstrukturen 14-1, .., 14-n, der ersten Elektrodenstruktur 14 unterhalb der beweglichen Elektrodenstruktur 16. Dies kann einen zusätzlichen Fertigungsaufwand durchaus aufwiegen. In diesem Fall kann das System, d.h. der MEMS-Aktuator 10, so ausgelegt werden, dass die Eintauchtiefe $\Delta z_1$ und der Überstand $\Delta z_3$ auf beiden Seiten die oben (für Anfangs- und Endposition) angegebenen Minimalwerte über den gesamten Auslenkungsbereich nicht unterschreiten.

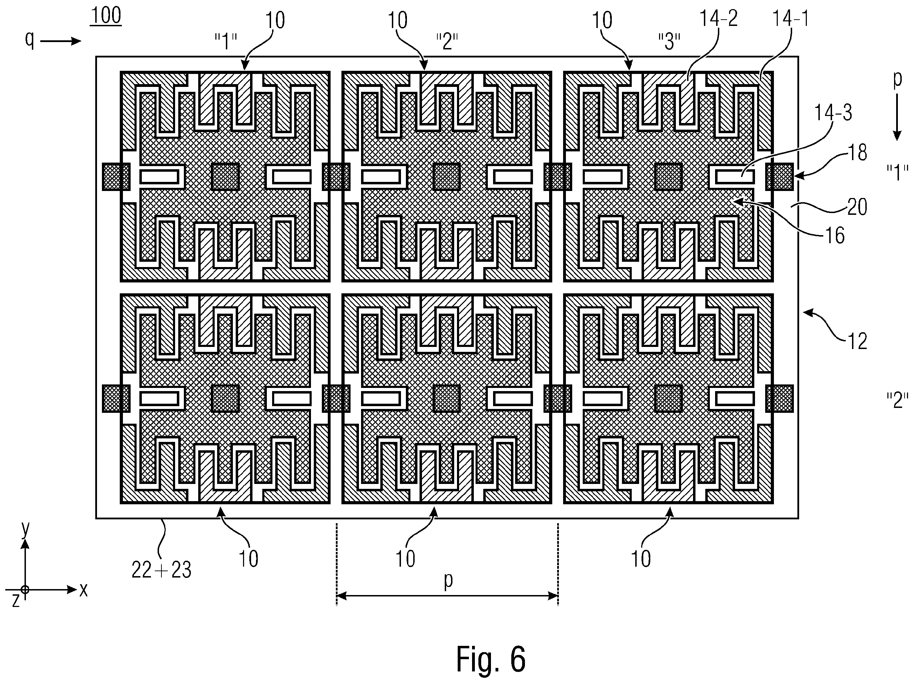

Fig. 6 zeigt eine schematische Aufsicht auf ein regelmäßiges Array 100 von MEMS-Aktuatoren gemäß einem weiteren Ausführungsbeispiel. Das MEMS-Array 100 von Fig. 6 weist eine Vielzahl von symmetrisch angeordneten MEMS-Aktuatoren 10 auf,. Es sollte deutlich werden, dass die dargestellte Array-Anordnung mit allen im vorhergehenden beschriebenen MEMS-Aktuatoren 10 umgesetzt werden kann.

Fig. 6 zeigt beispielhaft das MEMS-Aktuator-Array 100 in einer p x q-Arrayanordnung (p, q = positive ganze Zahlen), mit p = 2 Zeilen und q = 3 Spalten. Die Zeilen und Spalten sind aber im Wesentlichen beliebig fortsetzbar, um das MEMS-Aktuator-Array 100 mit beispielsweise zumindest 10.000 MEMS-Aktuatoren 10 zu erhalten. Zur besseren Sichtbarkeit der Elektrodenstrukturen 14, 16 sind die Federelemente 18-2 weggelassen und die Spiegel 20 voll transparent und nur durch ihre (schwarze) Kante dargestellt.

Gemäß einem Ausführungsbeispiel umfasst das MEMS-Aktuator-Array 100 eine Mehrzahl von MEMS-Aktuatoren 10 und ferner einer Ansteuereinrichtung 22 zum Bereitstellen einer eigenen Ansteuerspannung $V_S$ zwischen der ersten und zweiten Elektrodenstruktur 14, 16 der jeweiligen MEMS-Aktuatoren 10. Die Ansteuereinrichtung 22 ist beispielsweise ausgebildet, um jeden einzelnen MEMS-Aktuator 10 oder unterschiedliche Gruppen der MEMS-Aktuatoren 10 selektiv bzw. individuell mit einer eigenen Ansteuerspannung $V_S$ zu versehen.

Die Ansteuereinrichtung 22 kann ferner ausgebildet sein, um eine weitere eigene Ansteuerspannung $V'_S$ zwischen der zweiten und dritten Elektrodenstruktur 14, 24 der jeweiligen MEMS-Aktuatoren 10 bereitzustellen.

Gemäß einem Ausführungsbeispiel können die MEMS-Aktuatoren 10 Mikrospiegelelemente 20 aufweisen, die jeweils mit einer der zweiten Elektrodenstrukturen 16 gekoppelt sind, wobei die Mikrospiegelelemente 20 entsprechend der Auslenkung der zugeordneten zweiten Elektrodenstruktur 16 auslenkbar sind.

Gemäß einem Ausführungsbeispiel sind die zweiten Elektrodenstrukturen 16 der MEMS-Aktuatoren 10 basierend auf der Ansteuerspannung $V_S$ in zumindest eine Zwischenposition z auslenkbar. Gemäß einem Ausführungsbeispiel weisen die Ansteuerspannung $V_S$ und/oder die weitere Ansteuerspannung $V's$ eine jeweilige Adressspannung $V_B$, $V'_B$ für die MEMS-Aktuatoren 10 und ferner eine Bias-Spannung $V_{BIAS}$, $V'_{BIAS}$ für die MEMS-Aktuatoren 10, z.B. alle Aktuatoren, auf.

Gemäß einem Ausführungsbeispiel weist das MEMS-Aktuator-Array 100 ferner eine CMOS-Backplane als das Substrat 12 auf, wobei die CMOS-Backplane die Ansteuereinrichtung 22 und ferner Speicherzellen 23 aufweist.

Gemäß einem Ausführungsbeispiel weist das MEMS-Aktuator-Array 100 zumindest 10.000 MEMS-Aktuatoren 10 in einer p x q-Anordnung, mit p Zeilen und q Spalten, auf. Gemäß einem Ausführungsbeispiel können die MEMS-Aktuatoren 10 des MEMS-Aktuator-Arrays 100 einen Pitch P von kleiner oder gleich 20$\mu$m aufweisen.

Auch wenn im Vorhergehenden verschiedene Ausführungsbeispiele und die Wortwahl der Beschreibung sich auf translatorische MEMS-Aktuatoren 10, z.B. mit parallel auslenkenden Mikrospiegel (Senkspiegel), beziehen, ist das vorliegende erfindungsgemäße Konzept auch für andere MEMS-Elemente geeignet, speziell auch MEMS-Aktuatoren 10 ohne Spiegel.

Auch rotatorische Aktuatoren können auf diese Weise ausgelenkt werden, wobei die für Senkspiegel wohldefinierte Auslenkposition z dann näherungsweise durch die maximale Auslenkung der Kantenstruktur 16-0 der zweiten Elektrodenstruktur 16, d.h. die Auslenkung an den Fingerspitzen 16-A (soweit vorhanden), ersetzt werden kann.

Die vorliegende Erfindung kann sehr gut mit Federn entsprechend dem Patents [11] oder noch besser der Anmeldung [12] kombiniert werden.

Im Folgenden werden nochmals einige wesentliche technische Effekte des MEMS-Aktuators 100 zusammengefasst.

Die beschriebenen Ausführungsbeispiel ermöglichen die Realisierung eines "digital" angesteuerten mikromechanischen elektrostatischen Aktuators 10 mit einem großem Auslenkungsbereich $\Delta z_2$ bei kleinen lateralen Abmessungen zu realisieren, der gegenüber den in diesem Bereich üblichen Plattenaktuatoren eine verbesserte Abstufung der Auslenkungen sowie ein sehr geringes Übersprechen zwischen Nachbarpixeln zeigt.

Das vorliegende erfindungsgemäße Konzept eignet sich auch für MEMS-Aktuatoren 10, bei denen mehr als zwei Stufen der Auslenkung dadurch erreicht werden, dass mehrere Elektroden bzw. Teilelektrodenstrukturen 14-1, ..., 14-n der ersten Elektrodenstruktur 14 (oder Teilelektrodenstrukturen 14-1, ..., 14-n und 24-1, ..., 24-n der ersten und dritten Elektrodenstruktur 14 und 24) jeweils unabhängig voneinander mit einem binären oder diskreten Spannungswert adressiert werden. Zum Beispiel können der beweglichen Elektrodenstruktur 16 (auf festem elektrischem Potenzial, Biasspannung) vier elektrisch getrennte, feste Teileelektrodenstrukturen 14-1, ..., 14-4 gegenüberstehen, die jeweils an einer SRAM-Speicherzelle der Adresselektronik 22 angeschlossen sind. Jede SRAM-Zelle der Adresselektronik 22 kann jeweils nur einen von zwei (oder mehr diskreten) Zuständen annehmen und die angeschlossene Elektrode mit einer von zwei (oder mehr diskreten) Spannungen

$V_S$ beaufschlagen. Wenn die vier Teilelektrodenstrukturen 14-1, ... ,14-4 durch unterschiedliche Kantenlängen (z.B. Fingerzahlen etc.) unterschiedlich starke elektrostatische Kräfte erzeugen, können so mit einer rein digitalen (bzw. diskreten) Ansteuerung im Beispiel bis zu 16 Stufen im analogen Auslenkungsbereich des MEMS-Aktuators 10 angesteuert werden, d.h. ohne einen pull-in und ohne mechanische Anschläge. In diesem Fall kann durch die relativ gute Linearität der Kennlinie gemäß Ausführungsbeispielen eine deutliche Verbesserung der Abstufung der Auslenkungszustände gegenüber einem Plattenaktuator mit mehreren Elektroden erreicht werden.

Entsprechendes ginge grundsätzlich auch mit einer festen und mehreren beweglichen Elektroden.

Das vorliegende erfindungsgemäße Konzept eignet sich für mikromechanische Aktuatoren, insbesondere für phasenschiebende SLMs (SLM = Spatial Light Modulator, ein "Array" zur Modulation von Licht) mit sehr kleinen Pixeln (gemessen an den herstellbaren mechanischen Strukturgrößen oder der gewünschten Auslenkung). Solche SLMs sind besonders für die digitale Holografie interessant, sowohl für zukünftige holografische Displays, wie auch für (etwas näher liegende) Anwendungen wie z.B. universelle Laserpinzetten, Wellenfrontmodellierung und schnelle optische Schalter für Glasfasernetze, wo solche SLMs die gleichzeitige Aufspaltung sowie Steuerung der Richtung, Divergenz und Intensität von Laserstrahlen ermöglichen. Aber auch die Verwendung in anderen Geräten zur Mustererzeugung oder Steuerung der Lichtverteilung erscheint sinnvoll. Darüber hinaus sind vielfältige andere Anwendungen in der Mikroaktuatorik (auch ohne Mikrospiegel) wie auch der Sensorik denkbar.

Obwohl einige Aspekte der vorliegenden Offenbarung als Merkmale im Zusammenhang einer Vorrichtung beschrieben wurden, ist es klar, dass eine solche Beschreibung ebenfalls als eine Beschreibung entsprechender Verfahrensmerkmale betrachtet werden kann. Obwohl einige Aspekte als Merkmale im Zusammenhang mit einem Verfahren beschrieben wurden, ist klar, dass eine solche Beschreibung auch als eine Beschreibung entsprechender Merkmale einer Vorrichtung bzw. der Funktionalität einer Vorrichtung betrachtet werden können.

In der vorhergehenden detaillierten Beschreibung wurden teilweise verschiedene Merkmale in Beispielen zusammen gruppiert, um die Offenbarung zu rationalisieren. Diese Art der Offenbarung soll nicht als die Absicht interpretiert werden, dass die beanspruchten Beispiele mehr Merkmale aufweisen als ausdrücklich in jedem Anspruch angegeben sind. Vielmehr kann, wie die folgenden Ansprüche wiedergeben, der Gegenstand in weniger als allen Merkmalen eines einzelnen offenbarten Beispiels liegen.

Obwohl spezifische Ausführungsbeispiele hierin dargestellt und beschrieben wurden, wird einem Fachmann offensichtlich sein, dass eine Vielzahl von alternativen und/oder äquivalenten Implementierungen für die spezifischen dort gezeigten und dargestellten Ausführungsbeispiele ersetzt werden können, ohne von dem Gegenstand der vorliegenden Anmeldung abzuweichen. Dieser Anmeldungstext soll alle Adaptionen und Variationen der hierin beschriebenen und erörterten spezifischen Ausführungsbeispiele abdecken. Daher ist der vorliegende Anmeldungsgegenstand lediglich durch den Wortlaut der Ansprüche begrenzt.

**Literatur**

1. A. Gehner et al., "Micromirror arrays for wavefront correction", SPIE Vol. 4178, pp. 348-357 (2000).
2. Hubert Lakner et al.: "Design and Fabrication of Micromirror Arrays for UV-Lithography", Proc of SPIE Vol. 4561 (2001)
3. Christopher Aubuchon: 'Multi-Tilt Micromirror systems with concealed hinge structures', Patent US6900922
4. James Hall et al.: 'Adapting Texas Instruments (TI) DLP® technology to demonstrate a phase spatial light modulator', Proc. of SPIE Vol. 10932 (2019)
5. Texas Instruments Incorporated, "DMD 101 - Introduction to DMD technology", 2009
6. Peter Dürr et al.: 'Micro-actuator with extended analog deflection at low drive voltage', Proceedings of SPIE Vol. 6114 (2006)
7. Harald Schenk et al.: "A Novel Electrostatically Driven Torsional Actuator", Proc. 3rd Int. Conf. on Micro Opto Electro Mechanical Systems (1999)
8. L. Clark et al.: 'Vertical comb drive actuated deformable mirror device and method', Patent US 6,384,952
9. T. Sandner: 'Method of fabricating a micromechanical out of two-dimensional ...', Patent US 7929192
10. Veljko Milanovic et al.: 'Gimbal-less micro-electro-mechanical system ...', Patent US7295726
11. Peter Dürr et al.: 'MEMS Aktuator, System mit einer Mehrzahl vom MEMS Aktuatoren und Verfahren ...', Patent DE102015200626, patent application US2017297897AA
12. Peter Dürr et al.: 'MEMS mit einem beweglichen Strukturelement und MEMS-Array', deutsche Patentanmeldung 102018207783.5 (noch nicht öffentlich)

**Patentansprüche**

1. MEMS-Aktuator (10), mit folgenden Merkmalen:

    einem Substrat (12),
    einer ersten Elektrodenstruktur (14), die bezüglich des Substrats (12) feststehend angeordnet ist, wobei die erste Elektrodenstruktur (14) eine Mehrzahl von Teilelektrodenstrukturen (14-1, ..., 14-n) aufweist, die jeweils eine Kantenstruktur (14-0) aufweisen und getrennt voneinander elektrisch ansteuerbar sind, und einer zweiten Elektrodenstruktur (16) mit einer Kantenstruktur (16-0), wobei die zweite Elektrodenstruktur (16) mittels einer Federstruktur (18) auslenkbar mit dem Substrat (12) gekoppelt ist und mittels der ersten Elektrodenstruktur (14) elektrostatisch auslenkbar ist, um die Kantenstruktur (16-0) der zweiten Elektrodenstruktur (16) in eine einer Mehrzahl von diskreten Auslenkpositionen (z) zu bewegen, wobei die Kantenstrukturen (14-0, 16-0) der ersten und zweiten Elektrodenstruktur (14, 16) hinsichtlich einer Draufsicht gegenüberstehend ausgebildet und die gegenüberstehenden Abschnitte mit einem lateralen Abstand ($x_0$) voneinander beabstandet sind, und wobei die einzelnen Teilelektrodenstrukturen (14-1, ..., 14-n) der ersten Elektrodenstruktur (14) ausgebildet sind, um basierend auf einer elektrischen Ansteuerspannung ($V_S$) eine unterschiedliche, gleichgerichtete elektrostatische Kraft auf die zweite Elektrodenstruktur (16) auszuüben und die zweite Elektrodenstruktur (16) in die jeweilige diskrete Auslenkposition (z) auszulenken.

2. MEMS-Aktuator (10) gemäß Anspruch 1, ferner mit folgendem Merkmal:
    einer Ansteuereinrichtung (22) zum selektiven Ansteuern zumindest einer Teilmenge der Teilelektrodenstrukturen (14-1, ..., 14-n) der ersten Elektrodenstruktur (14) mit einem diskreten Spannungswert der Ansteuerspannung ($V_S$), um basierend auf der gewählten Teilmenge von Teilelektrodenstrukturen eine resultierende elektrostatische Kraft auf die zweite Elektrodenstruktur (16) mit einer entsprechenden Änderung der diskreten Auslenkposition der Kantenstruktur (16-0) der zweiten Elektrodenstruktur (16) zu erhalten.

3. MEMS-Aktuator (10) gemäß Anspruch 1 oder 2, wobei die elektrische Ansteuerspannung ($V_S$) eine Mehrzahl von unterschiedlichen, diskreten Spannungswerten ($V_{Si}$) aufweist, wobei basierend auf den unterschiedlichen diskreten Spannungswerten ($V_{Si}$) der elektrischen Ansteuerspannung ($V_S$) die Kantenstruktur (16-0) der zweiten Elektrodenstruktur (16) in unterschiedliche, diskrete, vertikal beabstandete Auslenkpositionen (z) auslenkbar ist, wobei beispielsweise die elektrische Ansteuerspannung ($V_S$) zwei unterschiedliche, diskrete Spannungswerte aufweist, um eine digitale Ansteuerung des MEMS-Aktuators (10) bereitzustellen.

4. MEMS-Aktuator (10) gemäß einem der vorhergehenden Ansprüche, wobei sich die Teilelektrodenstrukturen (14-1, ... , 14-n) der ersten Elektrodenstruktur (14) hinsichtlich ihrer Größe und/oder des jeweiligen lateralen Abstands zu der zweiten Elektrodenstruktur (16) zueinander unterscheiden.

5. MEMS-Aktuator (10) gemäß einem der vorhergehenden Ansprüche, wobei die erste Elektrodenstruktur (14) "n" Teilelektrodenstrukturen (14-1, ..., 14-n) aufweist, die bei einem diskreten Spannungswert der elektrischen Ansteuerspannung ($V_S$) eine um einen vorgegebenen Faktor unterschiedliche, gleichgerichtete elektrostatische Kraft auf die zweite Elektrodenstruktur (16) ausüben, wobei beispielsweise jede der "n" Teilelektrodenstrukturen (14-1, ..., 14-n) einer unterschiedlichen Bit-Position eines n-Bit-Worts zuordenbar ist, wobei die jeweilige Teilelektrodenstruktur einer umso höherwertigen Bit-Bitposition des n-Bit-Worts zugeordnet ist, je größer bei einer elektrischen Anregung die elektrostatische Kraft dieser Teilelektrodenstruktur auf die zweite Elektrodenstruktur (16) ist, und wobei der Wert des jeweiligen Bits des n-Bit-Worts den Aktivierungszustand der zugeordneten Teilelektrodenstruktur widergibt.

6. MEMS-Aktuator (10) gemäß einem der vorhergehenden Ansprüche, wobei die erste und zweite Elektrodenstruktur (14, 16) in einer Ebene parallel zu dem Substrat (12) um einen lateralen Abstand beabstandet sind, wobei die zweite Elektrodenstruktur (16) in der minimalen Auslenkposition in der ersten Elektrodenstruktur eine erste Eintauchtiefe ($\Delta z_1$) aufweist, wobei die erste Auslenkposition ($\Delta z_1$) zwischen dem -0,25-fachen, 0-fachen oder 0,5-fachen Wert und dem 1,5-fachen Wert des lateralen Abstands ($x_0$) liegt.

7. MEMS-Aktuator (10) gemäß einem der vorhergehenden Ansprüche, wobei in einer maximalen Auslenkposition ($\Delta z_2$) der zweiten Elektrodenstruktur (16) in der ersten Elektrodenstruktur (14) ein vertikaler Überstand ($\Delta z_3$) zwischen der ersten und zweiten Elektrodenstruktur zumindest den 1-fachen, 1,5-fachen oder 2-fachen Wert des lateralen Abstand ($x_0$) aufweist.

8. MEMS-Aktuator (10) gemäß einem der vorhergehenden Ansprüche, wobei zumindest ein Teil der Kantenstrukturen (14-0) der ersten Elektrodenstruktur (14) eine Finger- oder Kammstruktur aufweisen, und wobei die Kantenstruktur (16-0) der zweiten Elektrodenstruktur (16) eine weitere Finger- oder Kammstruktur aufweist.

9. MEMS-Aktuator (10) gemäß einem der vorhergehenden Ansprüche, wobei die Kantenstrukturen (14-0) der ersten Elektrodenstruktur (14) und die Kantenstruktur (16-0) der zweiten Elektrodenstruktur (16) zumindest bereichsweise ineinandergreifend ausgebildet sind.

10. MEMS-Aktuator (10) gemäß einem der vorhergehenden Ansprüche, ferner mit folgendem Merkmal:

einer dritten Elektrodenstruktur (24), die bezüglich des Substrats (12) feststehend angeordnet ist, wobei die zweite Elektrodenstruktur (16) zwischen der ersten und dritten Elektrodenstruktur (14, 24) angeordnet und auslenkbar ist, wobei die zweite Elektrodenstruktur (16) mittels der dritten Elektrodenstruktur (24) elektrostatisch auslenkbar ist, um die Kantenstruktur (16-0) der zweiten Elektrodenstruktur (16) in eine weitere diskrete Auslenkposition zu bewegen;
wobei die erste und dritte Elektrodenstruktur (14, 24) ausgebildet sind, um bei einer elektrischen Anregung eine entgegengesetzte elektrostatische Kraft auf die zweite Elektrodenstruktur (16) auszuüben.
wobei beispielsweise die dritte Elektrodenstruktur (24) eine Mehrzahl von Teilelektrodenstrukturen (24-1, ..., 24-m) aufweist, die jeweils eine Kantenstruktur (24-0) aufweisen und getrennt voneinander elektrisch ansteuerbar sind, und wobei die einzelnen Teilelektrodenstrukturen (24-1, ..., 24-m) der dritten Elektrodenstruktur (24) ausgebildet sind, um bei einer elektrischen Anregung eine unterschiedliche, gleichgerichtete elektrostatische Kraft auf die zweite Elektrodenstruktur (16) auszuüben, oder
wobei beispielsweise die zweite und dritte Elektrodenstruktur (16, 24) in einer Ebene parallel zu dem Substrat (12) um einen lateralen Abstand beabstandet sind, wobei die zweite Elektrodenstruktur (16) in der minimalen Auslenkposition in der dritten Elektrodenstruktur (24) eine zweite Eintauchtiefe aufweist, wobei die zweite Eintauchtiefe zwischen dem -0,25-fachen, 0-fachen oder 0,5-fachen Wert und dem 1,5-fachen Wert des lateralen Abstands beträgt.

11. MEMS-Aktuator (10) gemäß einem der vorhergehenden Ansprüche, wobei die zweite Elektrodenstruktur (16) translatorisch und/oder rotatorisch bezüglich der ersten Elektrodenstruktur (14) oder bezüglich der ersten und dritten Elektrodenstruktur (14, 24) auslenkbar ist.

12. MEMS-Aktuator-Array (100), mit folgenden Merkmalen:

einer Mehrzahl von MEMS-Aktuatoren (10) gemäß Anspruch 10 oder gemäß Anspruch 11 wenn abhängig von Anspruch 10, und

einer Ansteuereinrichtung (22) zum individuellen Ansteuern der jeweiligen Teilelektrodenstrukturen (14-1, ..., 14-n) der ersten Elektrodenstrukturen (14) und/oder zum individuellen Ansteuern der jeweiligen dritten Elektrodenstruktur (24-1, ..., 24-m) der Mehrzahl von MEMS-Aktuatoren (10),

wobei die zweiten Elektrodenstrukturen (16) der MEMS-Aktuatoren (10) basierend auf der Ansteuerspannung ($V_S$) in zumindest eine Auslenkposition jeweils zwischen der minimalen Auslenkposition und der maximalen Auslenkposition in der ersten Elektrodenstruktur (14) auslenkbar sind, und/oder

wobei die zweiten Elektrodenstrukturen (16) der MEMS-Aktuatoren (10) basierend auf der weiteren Ansteuerspannung ($V_{Si}$) in zumindest eine Auslenkposition jeweils zwischen der maximalen Auslenkposition in der ersten Elektrodenstruktur (14) und maximalen Auslenkposition in der dritten Elektrodenstruktur (24) auslenkbar sind.

13. MEMS-Aktuator-Array (100) gemäß Anspruch 12, wobei die MEMS-Aktuatoren (10) Mikrospiegelelemente (20), die jeweils mit einer der zweiten Elektrodenstrukturen (16) gekoppelt sind, aufweisen, wobei die Mikrospiegelelemente (20) entsprechend der Auslenkung der zweiten Elektrodenstruktur (16) auslenkbar sind.

14. MEMS-Aktuator-Array (100) gemäß einem der Ansprüche 12 oder 13, wobei die Ansteuerspannung ($V_S$) und/oder die weitere Ansteuerspannung ($V_{Si}$) eine jeweilige Adressspannung ($V_B$) für die MEMS-Aktuatoren (10) und ferner eine Bias-Spannung ($V_{BIAS}$) für die MEMS-Aktuatoren (10) aufweisen.

15. MEMS-Aktuator-Array (100) gemäß einem der Ansprüche 12 bis 14, mit folgenden Merkmalen:
Einer CMOS-Backplane als das Substrat (12), wobei die CMOS-Backplane die Ansteuereinrichtung (22) und ferner Speicherzellen aufweist.

## Claims

1. MEMS actuator (10), comprising:

a substrate (12),
a first electrode structure (14) that is stationary with respect to the substrate (12), wherein the first electrode structure (14) comprises a plurality of partial electrode structures (14-1, ..., 14-n), each of which comprises an edge structure (14-0) and can be electrically controlled separately, and
a second electrode structure (16) with an edge structure (16-0), wherein the second electrode structure (16) is deflectably coupled to the substrate (12) by means of a spring structure (18) and is electronically deflectable by means of the first electrode structure (14) to move the edge structure (16-0) of the second electrode structure (16) into one of a plurality of discrete deflection positions (z),

wherein the edge structures (14-0, 16-0) of the first and second electrode structures (14, 16) are configured to be opposite to each other with respect to a top view and the opposite portions are spaced apart by a lateral distance ($x_0$), and wherein the individual partial electrode structures (14-1, ..., 14-n) of the first electrode structure (14) are configured to apply a different, equally directed electrostatic force on the second electrode structure (16) based on an electric control voltage ($V_S$) and to deflect the second electrode structure (16) into the respective discrete deflection position (z).

2. MEMS actuator (10) according to claim 1, further comprising:

a control (22) for selectively controlling at least one subset of the partial electrode structures (14-1, ..., 14-n) of the first electrode structure (14) with a discrete voltage value of the control voltage ($V_S$) to obtain, based on the selected subset of partial electrode structures, a resulting electrostatic force on the second electrode structure (16) with a corresponding change of the discrete deflection position of the edge structure (16-0) of the second electrode structure (16).

3. MEMS actuator (10) according to claim 1 or 2, wherein the electric control voltage ($V_S$) comprises a plurality of different discrete voltage values ($V_{Si}$), wherein, based on the different discrete voltage values ($V_{Si}$) of the electric control voltage ($V_S$), the edge structure (16-0) of the second electrode structure (16) is deflectable in different discrete, vertically spaced-apart deflection positions (z),
wherein, for example, the electric control voltage ($V_S$) comprises two different discrete voltage values to provide digital control of the MEMS actuator (10).

4. MEMS actuator (10) according to any one of the preceding claims, wherein the partial electrode structures (14-1, ..., 14-n) of the first electrode structure (14) differ with respect to their size and/or the respective lateral distance to the second electrode structure (16).

5. MEMS actuator (10) according to any one of the preceding claims, wherein the first electrode structure (14) comprises "n" partial electrode structures (14-1, ..., 14-n) that apply, at a discrete voltage value of the electric control voltage ($V_S$), an equally directed electrostatic force differing by a predetermined factor to the second electrode structure (16), wherein, for example, each of the "n" partial electrode structures (14-1, ..., 14-n) can be allocated to a different bit position of an n-bit word, wherein the respective partial electrode structure is allocated to a bit position of the bit word of higher significance the greater the electrostatic force of this partial electrode structure on the second electrode structure (16) during electric excitation, and wherein the value of the respective bit of the bit word reflects the activation state of the allocated partial electrode structure.

6. MEMS actuator (10) according to any one of the preceding claims, wherein the first and second electrode structures (14, 16) are spaced apart by a lateral distance in a plane parallel to the substrate (12), wherein the second electrode structure (16) comprises a first immersion depth ($\Delta z_1$) in the minimum deflection position in the first electrode structure (14), wherein the first deflection position ($\Delta z_1$) is between -0.25 times, 0 times or 0.5 times the value and 1.5 times the value of the lateral distance ($x_0$).

7. MEMS actuator (10) according to any one of the preceding claims, wherein, in a maximum deflection position ($\Delta z_2$) of the second electrode structure (16) in the first electrode structure (14), a vertical overlap ($\Delta z_3$) between the first and second electrode structures comprises at least 1 times, 1.5 times or 2 times the value of the lateral distance ($x_0$).

8. MEMS actuator (10) according to any one of the preceding claims, wherein at least part of the edge structures (14-0) of the first electrode structure (14) comprise a finger or comb structure and wherein the edge structure (16-0) of the second electrode structure (16) comprises a further finger or comb structure.

9. MEMS actuator (10) according to any one of the preceding claims, wherein the edge structures (14-0) of the first electrode structure (14) and the edge structure (16-0) of the second electrode structure (16) are configured to interdigitate at least in some areas.

10. MEMS actuator (10) according to any one of the preceding claims, further comprising:

   a third electrode structure (24) that is stationary with respect to the substrate (12), wherein the second electrode structure (16) is arranged between the first and third electrode structures (14, 24) and is deflectable, wherein the second electrode structure (16) is electrostatically deflectable by means of the third electrode structure (24) to move the edge structure (16-0) of the second electrode structure (16) into a further discrete deflection position,
wherein the first and third electrode structures (14, 24) are configured to apply, during electric excitation, an opposite electrostatic force on the second electrode structure (16),
wherein, for example, the third electrode structure (24) comprises a plurality of partial electrode structures (24-1, ..., 24-m), each of which comprises an edge structure (24-0) and can be electrically controlled separately, and wherein the individual partial electrode structures (24-1, ..., 24-m) of the third electrode structure (24) are configured to apply, during electric excitation, a different, equally directed electrostatic force on the second electrode structure (16), or
wherein, for example, the second and third electrode structures (16, 24) are spaced apart by a lateral distance in a plane parallel to the substrate (12), wherein the second electrode structure (16) comprises a second immersion depth in the minimum deflection position in the third electrode structure (24), wherein the second immersion depth is between -0.25 times, 0 times or 0.5 times the value and 1.5 times the value of the lateral distance.

11. MEMS actuator (10) according to any one of the preceding claims, wherein the second electrode structure (16) can be deflected in a translatory and/or rotatory manner with respect to the first electrode structure (14) or with respect to the first and third electrode structures (14, 24).

12. MEMS actuator array (100), comprising:

   a plurality of MEMS actuators (10) according to claim 10 or according to claim 11 when depending on claim 10, and a control (22) for individually controlling the respective partial electrode structures (14-1, ..., 14-n) of the first electrode structures (14) and/or for individually controlling the respective third electrode structure (24-1, ..., 24-m) of the plurality of MEMS actuators (10),
   wherein the second electrode structures (16) of the MEMS actuators (10) can be deflectable into at least one deflection position, each between the minimum deflection position and the maximum deflection position in the first electrode structure (14), based on the control voltage ($V_S$), and/or
   wherein the second electrode structures (16) of the MEMS actuators (10) are deflectable into at least one deflection position, each between the maximum deflection position in the first electrode structure (14) and the maximum deflection position in the third electrode structure (24), based on the further control voltage ($V_{Si}$).

13. MEMS actuator array (100) according to claim 12, wherein the MEMS actuators (10) comprise micromirror elements (20) that are each coupled to one of the second electrode structures (16), wherein the micromirror elements (20) are deflectable corresponding to the deflection of the second electrode structure (16).

14. MEMS actuator array (100) according to any one of claims 12 or 13, wherein the control voltage ($V_S$) and/or the further control voltage ($V_{Si}$) comprise a respective address voltage ($V_B$) for the MEMS actuators (10) and further a bias voltage ($V_{BIAS}$) for the MEMS actuators (10).

15. MEMS actuator array (100) according to any one of claims 12 to 14, comprising:
a CMOS backplane as the substrate (12), wherein the CMOS backplane comprises the control (22) and further memory cells.

## Revendications

1. Actionneur de type MEMS (10), avec les caractéristiques suivantes :

un substrat (12),
une première structure d'électrode (14) qui est disposée de manière fixe par rapport au substrat (12), dans lequel la première structure d'électrode (14) présente une pluralité de structures d'électrode partielles (14-1, ..., 14-n) qui présentent à chaque fois une structure d'arête (14-0) et peuvent être commandées électriquement de manière séparée les unes des autres, et
une deuxième structure d'électrode (16) avec une structure d'arête (16-0), la deuxième structure d'électrode (16) étant couplée au substrat (12) de manière déviable à l'aide d'une structure à ressort (18) et peut être déviée électrostatiquement à l'aide de la première structure d'électrode (14) pour déplacer la structure d'arête (16-0) de la deuxième structure d'électrode (16) dans une pluralité de positions de déviation discrètes (z),
dans lequel les structures d'arête (14-0, 16-0) de la première et deuxième structure d'électrode (14, 16) sont conçues en face les unes des autres en vue de dessus et les parties en face les unes des autres sont espacées les unes des autres d'une distance latérale ($x_0$), et

dans lequel les structures d'électrode partielles individuelles (14-1, ..., 14-n) de la première structure d'électrode (14) sont conçues pour exercer, sur la base d'une tension de commande électrique ($V_S$), une force électrostatique redressée différente sur la deuxième structure d'électrode (16) et pour dévier la deuxième structure d'électrode (16) dans la position de déviation (z) discrète respective.

2. Actionneur de type MEMS (10) selon la revendication 1, en outre avec les caractéristiques suivantes :
un dispositif de commande (22) pour commander de manière sélective au moins une quantité partielle de structures d'électrode partielles (14-1, ..., 14-n) de la première structure d'électrode (14) avec une valeur de tension discrète de la tension de commande ($V_S$) pour obtenir, sur la base de la quantité partielle choisie de structures d'électrode partielles, une force électrostatique résultante sur la deuxième structure d'électrode (16) avec une modification correspondante de la position de déviation discrète de la structure d'arête (16-0) de la deuxième structure d'électrode (16).

3. Actionneur de type MEMS (10) selon la revendication 1 ou 2, dans lequel la tension de commande électrique ($V_S$) présente une pluralité de valeurs de tension discrètes différentes ($V_{Si}$), dans lequel, sur la base des valeurs de tension discrètes différentes ($V_{Si}$) de la tension de commande électrique ($V_S$), la structure d'arête (16-0) de la deuxième structure d'électrode (16) peut être déviée dans différentes positions de déviation (z) discrètes et à distance verticalement,
dans lequel à titre d'exemple la tension de commande électrique ($V_S$) présente deux valeurs de tension discrètes différentes pour fournir une commande numérique de l'actionneur de type MEMS (10).

4. Actionneur de type MEMS (10) selon l'une des revendications précédentes, dans lequel les structures d'électrode partielles (14-1, ..., 14-n) de la première structure d'électrode (14) se distinguent les unes des autres concernant leur taille et/ou leur distance latérale respective par rapport à la deuxième structure d'électrode (16).

5. Actionneur de type MEMS (10) selon l'une des revendications précédentes, dans lequel la première structure d'électrode (14) présente « n » structures d'électrode partielles (14-1, ..., 14-n) qui exercent sur la deuxième structure d'électrode (16), pour une valeur de tension discrète de la tension de commande électrique ($V_S$), une force électrostatique redressée différente d'un facteur prédéterminé,
dans lequel à titre d'exemple chacune des « n » structures d'électrode partielles (14-1, ..., 14-n) peut être associée à une position de bit différente d'un mot à n bits, dans lequel la structure d'électrode partielle respective est associée à une position de bit du mot à n bits d'une valeur d'autant supérieure que la force électrostatique de cette structure d'électrode partielle sur la deuxième structure d'électrode (16) est grande lors d'une excitation électrique, et dans lequel la valeur du bit respectif du mot à n bits reflète l'état d'activation de la structure d'électrode partielle associée.

6. Actionneur de type MEMS (10) selon l'une des revendications précédentes, dans lequel la première et la deuxième structure d'électrode (14, 16) sont espacées d'une distance latérale dans un plan parallèle au substrat (12), la deuxième structure d'électrode (16) présentant une première profondeur d'immersion ($\Delta z_1$) dans la position de déviation minimale dans la première structure d'électrode (14), la première position de déviation ($\Delta z_1$) se situant entre -0,25 fois, 0 fois ou 0,5 fois la valeur et 1,5 fois la valeur de la distance latérale ($x_0$).

7. Actionneur de type MEMS (10) selon l'une des revendications précédentes, dans lequel dans une position de déviation maximale ($\Delta z_2$) de la deuxième structure d'électrode (16) dans la première structure d'électrode (14) une saillie verticale ($\Delta z_3$) entre la première et la deuxième structure d'électrode présente au moins 1 fois, 1,5 fois ou 2 fois la valeur de la distance latérale ($x_0$).

8. Actionneur de type MEMS (10) selon l'une des revendications précédentes, dans lequel au moins une partie des structures d'arête (14-0) de la première structure d'électrode (14) présentent une structure en doigt ou en peigne et dans lequel la structure d'arête (16-0) de la deuxième structure d'électrode (16) présente une autre structure en doigt ou en peigne.

9. Actionneur de type MEMS (10) selon l'une des revendications précédentes, dans lequel les structures d'arête (14-0) de la première structure d'électrode (14) et la structure d'arête (16-0) de la deuxième structure d'électrode (16) sont conçues pour s'emboîter au moins par sections.

10. Actionneur de type MEMS (10) selon l'une des revendications précédentes, en outre avec les caractéristiques suivantes :

une troisième structure d'électrode (24) qui est disposée de manière fixe par rapport au substrat (12), dans lequel la deuxième structure d'électrode (16) est disposée entre la première et la troisième structure d'électrode (14, 24) et peut être déviée, la deuxième structure d'électrode (16) étant déviable électrostatiquement à l'aide de la troisième structure d'électrode (24) pour déplacer la structure d'arête (16-0) de la deuxième structure d'électrode (16) dans une autre position de déviation discrète ;
dans lequel la première et la troisième structure d'électrode (14, 24) sont conçues pour exercer, lors d'une excitation électrique, une force électrostatique opposée sur la deuxième structure d'électrode (16),
dans lequel à titre d'exemple la troisième structure d'électrode (24) présente une pluralité de structures d'électrode partielles (24-1, ..., 24-m) qui présentent à chaque fois une structure d'arête (24-0) et peuvent être commandées électriquement de manière séparée les unes des autres, et dans lequel les structures d'électrode partielles individuelles (24-1, ..., 24-m) de la troisième structure d'électrode (24) sont conçues pour exercer, lors d'une excitation électrique, une force électrostatique redressée différente sur la deuxième structure d'électrode (16), ou
dans lequel à titre d'exemple la deuxième et la troisième structure d'électrode (16, 24) sont espacées d'une distance latérale dans un plan parallèle au substrat (12), la deuxième structure d'électrode (16) présentant une seconde profondeur d'immersion dans la position de déviation minimale dans la troisième structure d'électrode (24), la seconde profondeur d'immersion se situant entre -0,25 fois, 0 fois ou 0,5 fois la valeur de la distance latérale et 1,5 fois la valeur.

11. Actionneur de type MEMS (10) selon l'une des revendications précédentes, dans lequel la deuxième structure d'électrode (16) peut être déviée en translation et/ou en rotation par rapport à la première structure d'électrode (14) ou par rapport à la première et la troisième structure d'électrode (14, 24).

12. Réseau d'actionneurs de type MEMS (100), avec les caractéristiques suivantes :

une pluralité d'actionneurs de type MEMS (10) selon la revendication 10 ou selon la revendication 11 lorsqu'elle est dépendante de la revendication 10, et un dispositif de commande (22) pour commander individuellement les structures d'électrode partielles respectives (14-1, ..., 14-n) des premières structures d'électrodes (14) et/ou pour commander individuellement la troisième structure d'électrode (24-1, ..., 24-m) de la pluralité d'actionneurs de type MEMS (10),
dans lequel les deuxièmes structures d'électrodes (16) des actionneurs de type MEMS (10) peuvent être déviées sur la base de la tension de commande ($V_S$) dans au moins une position de déviation à chaque fois entre la position de déviation minimale et la position de déviation maximale dans la première structure d'électrode (14), et/ou

dans lequel les deuxièmes structures d'électrodes (16) des actionneurs de type MEMS (10) peuvent être déviées sur la base de l'autre tension de commande ($V_{Si}$) dans au moins une position de déviation à chaque fois entre la position de déviation maximale dans la première structure d'électrode (14) et la position de déviation maximale dans la troisième structure d'électrode (24).

13. Réseau d'actionneurs de type MEMS (100) selon la revendication 12, dans lequel les actionneurs de type MEMS (10) présentent des éléments de micro miroirs (20) qui sont couplés à chaque fois à une des deuxièmes structures d'électrodes (16), les éléments de micro miroirs (20) pouvant être déviés conformément à la déviation de la deuxième structure d'électrode (16).

14. Réseau d'actionneurs de type MEMS (100) selon l'une des revendications 12 ou 13, dans lequel la tension de commande ($V_S$) et/ou l'autre tension de commande ($V_{Si}$) présentent une tension d'adresse respective ($V_B$) pour les actionneurs de type MEMS (10) et en outre une tension de polarisation ($V_{BIAS}$) pour les actionneurs de type MEMS (10).

15. Réseau d'actionneurs de type MEMS (100) selon l'une des revendications 12 à 14, avec les caractéristiques suivantes :
un fond de panier CMOS servant de substrat (12), dans lequel le fond de panier CMOS présente le dispositif de commande (22) et en outre des cellules de mémoire.

Fig. 1

EP 3 997 030 B1

Anfangszustand
minimaler Adresswert $V_{B-MIN}$

Endzustand
maximaler Adresswert $V_{B-MAX}$

$b_{16}$

16

$d_{16}$

16-0

16-A
Aktuatorfinger

16-A

Überstand $\Delta z_3$

$\Delta z_1$ Eintauchtiefe $\Delta z_1$

$\Delta z_1$

14

$d_{14}$

14-0

$\Delta z_2$

14-A
Elektrodenfinger

Überstand $\Delta z_3$

$b_{14}$

$x_0$

14-A

14-A

horizontales
Gap $x_0$

z

y ⊙ → x

Fig. 2a

Fig. 2b

Fig. 3

invertierter Aufbau

doppelt wirkender Aktuator

14-A    14-A

14-A
Elektrodenfinger
oben

14

$\Delta z_1$ minimale Eintauchtiefe oben

14

$\Delta z_1$ minimale Eintauchtiefe

16

16-A
Aktuatorfinger
an unterster Position

16

24

16-A

24-A
Elektrodenfinger
unten

24-A

$x_0$

16-A

24-A

$\Delta z_4 = \Delta z_3$
minimaler Überstand unten

$x_0$

horizontales
Gap $x_0$

z

y    x

25

EP 3 997 030 B1

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6900922 B, Christopher Aubuchon
- US 6384952 B, L. Clark
- US 7929192 B, T. Sandner
- US 7295726 B, Veljko Milanovic
- DE 102015200626, Peter Dürr
- US 2017297897 AA
- DE 102018207783, Peter Dürr

**In der Beschreibung aufgeführte Nicht-Patentliteratur**

- High Aspect Ratio Micromirrors With Large Static Rotation and Piston Actuation. **KWON S et al.** IEEE PHOTONICS TECHNOLOGY LETTERS. IEEE SERVICE CENTER, 01 August 2004, vol. 16, 1891-1893
- **A. GEHNER et al.** Micromirror arrays for wavefront correction. *SPIE*, 2000, vol. 4178, 348-357
- **HUBERT LAKNER et al.** Design and Fabrication of Micromirror Arrays for UV-Lithography. *Proc of SPIE*, 2001, vol. 4561
- **JAMES HALL et al.** Adapting Texas Instruments (TI) DLP® technology to demonstrate a phase spatial light modulator. *Proc. of SPIE*, 2019, vol. 10932
- **TEXAS INSTRUMENTS INCORPORATED**. *DMD 101 - Introduction to DMD technology*, 2009
- **PETER DÜRR et al.** Micro-actuator with extended analog deflection at low drive voltage. *Proceedings of SPIE*, 2006, vol. 6114
- **HARALD SCHENK et al.** A Novel Electrostatically Driven Torsional Actuator. *Proc. 3rd Int. Conf. on Micro Opto Electro Mechanical Systems*, 1999